# EUROPEAN PATENT APPLICATION

(11) **EP 4 561 314 A1**
(43) Date of publication of application: **28.05.2025**
(21) Application number: 24204216.6
(22) Date of filing: 02.10.2024
(51) Int. Cl.: H10K 59/122, H10K 59/35, H10K 59/38

(54) **LIGHT EMITTING DISPLAY DEVICE**

(30) Priority: 24.11.2023 KR 20230165976
(71) Applicant: Samsung Display Co., Ltd., Gyeonggi-do 17113 (KR)
(72) Inventor: CHOI, Kook Hyun, Giheung-gu, Yongin-si, Gyeonggi-do (KR); RYU, Soo-Hye, Giheung-gu, Yongin-si, Gyeonggi-do (KR); PARK, Hong-Jo, Giheung-gu, Yongin-si, Gyeonggi-do (KR); LEE, Jun Hee, Giheung-gu, Yongin-si, Gyeonggi-do (KR); CHOI, Beohm Rock, Giheung-gu, Yongin-si, Gyeonggi-do (KR)
(74) Representative: Dr. Weitzel & Partner

(57) **Abstract**

A light emitting display device includes: a substrate, a plurality of anodes located on the substrate; a pixel defining layer defining a plurality of first openings overlapping the plurality of anodes, respectively; a plurality of light emitting layers located within the plurality of first openings of the pixel defining layer, respectively; a cathode disposed on the plurality of light emitting layers and the pixel defining layer; an encapsulation layer located on the cathode; and a plurality of color filters corresponding to different colors and located on the encapsulation layer. The plurality of color filters define a plurality of second openings in each of which only one color filter of the color filters is located, and include a light blocking area in which at least two color filters of the color filters are overlapped in a plan view, and the first opening or the second opening has an oval shape.

## Description

### BACKGROUND

### 1. Field

This invention relates to a light emitting display device.

### 2. Description of the Related Art

A display device is a device that displays a screen and includes a liquid crystal display ("LCD") device and an organic light emitting diode ("OLED") device.

These display devices are used in various electronic devices such as mobile phones, navigation devices, digital cameras, electronic books, portable game consoles, and various terminals.

A display device, such as an organic light emitting display device, may have a structure that allows the display device to be bent or folded using a flexible substrate.

In addition, in small electronic devices such as mobile phones, optical elements such as cameras and optical sensors are formed in the bezel area around the display area. However, as the size of the display screen increases, the size of the area surrounding the display area gradually decreases. Technology is being developed that allows optical sensors to be positioned on the back of the display area.

### SUMMARY

The embodiments are intended to reduce diffraction patterns that occur when external light is reflected or to lower reflectance. Embodiments are intended to provide a light emitting display device that generates less color separation of external light or generates a constant diffraction pattern regardless of angle.

In addition, embodiments do not form a black light blocking layer on the front of the display panel, but overlap a plurality of color filters to prevent external light from being reflected or transmitted, thereby reducing the resulting diffraction pattern or causing less color separation of external light.

The invention is defined by the features of the independent claims. The dependent claims describe preferred embodiments.

A light emitting display device according to an embodiment includes: a substrate; a plurality of anodes located on the substrate; a pixel defining layer defining a plurality of first openings overlapping the plurality of anodes, respectively; a plurality of light emitting layers located within the plurality of first openings of the pixel defining layer, respectively; a cathode disposed on the plurality of light emitting layers and the pixel defining layer; an encapsulation layer located on the cathode; and a plurality of color filters corresponding to different colors and located on the encapsulation layer, where the plurality of color filters define a plurality of second openings in each of which only one color filter of the plurality of color filters is located, and include a light blocking area in which at least two color filters of the plurality of color filters are overlapped in a plan view, and at least one first opening among the plurality of first openings of the pixel defining layer and at least one second opening among the plurality of second openings of the color filter each has an oval shape in the plan view. Especially most or all of the first openings and most or all of the second openings have the oval shape in the plan view.

The plurality of first openings may include four or more major axes (which also may be termed as major axes), the plurality of second openings may include four or more major axes, and an angle formed by major axes of the oval shape possessed by two of the plurality of first openings or an angle formed by major axes possessed by two of the plurality of second openings may be 45 degrees or less. In other words, the plurality of first openings may be disposed with their major axes at four or more different angles with respect to a basis direction, for example a row direction of the pixels defined by the pixel defining layer, especially a horizontal direction of the display device. Accordingly, the plurality of second openings may be disposed with their major axes at four or more different angles with respect to the basis direction. The major axis angles of the first openings can be arranged at intervals of 45 degrees or less. Accordingly, the major axis angles of the second openings can be arranged at intervals of 45 degrees or less. That is, the at least four or more different angles differ from each other by the mentioned interval, for example 45 degrees or less. The major axis angles of the first openings and/or of second openings can be arranged regular, that is the intervals are constant.

Each of the plurality of first openings or each of the plurality of second openings may have an eccentricity of 0.2 to 0.85.

The plurality of first openings and the plurality of second openings that overlap the first openings in the plan view may be formed at regular intervals in the plan view. The first opening and the second opening that overlaps the first opening in the plan view may have a horizontal gap of more than 0 micrometer (µm) and less than or equal to 20 µm.

The first opening and the second opening that overlaps the first opening in the plan view may have the same major axis direction or may have an angle of 20 degrees or less between major axis directions thereof.

The first opening or the second opening may have a planar shape that merges portions of at least two elliptical shapes with different eccentricities in the plan view.

The first opening or the second opening may have a planar shape formed by cutting a first ellipse with a first eccentricity and a second ellipse with a second eccentricity in a first direction and then merging a cut portion of the first ellipse and a cut portion of the second ellipse.

In the light blocking area of the color filter, a blue color filter and a red color filter may overlap each other, and each of the plurality of second openings may overlap one of the blue color filter, the red color filter, and a green color filter.

A light emitting display device according to an embodiment includes: a substrate; a plurality of anodes located on the substrate; a pixel defining layer defining a plurality of first openings overlapping the plurality of anodes, respectively; a plurality of light emitting layers located within the plurality of first openings of the pixel defining layer, respectively; a cathode disposed on the plurality of light emitting layers and the pixel defining layer; an encapsulation layer located on the cathode, and a plurality of color filters corresponding to different colors and located on the encapsulation layer, where the plurality of color filters define a plurality of second openings in each of which only one color filter of the plurality of color filters is located, and include a light blocking area in which at least two color filters of the plurality of color filters are overlapped in a plan view, and one of a first opening of the pixel defining layer among the plurality of first openings and a second opening of the color filter overlapping the first opening, among the second openings, has a circular shape, and the other one of the first opening and the second opening has an elliptical shape in the plan view. In other words, at least one second opening overlaps one first opening and one of these openings - first opening or the second opening - has a circular shape in the plan view and the other has an elliptical shape in the plan view. Especially, several or all second openings overlap one of the first openings, respectively, and one of these openings of each overlapping pair of openings has a circular shape in the plan view and the other has an elliptical shape in the plan view.

Some or all of the first openings or some or all of the second openings may have the oval shape and include four or more major axes, and the angle formed by the major axes may be 45 degrees or less. In other words, some or all of first openings or some or all of the second openings may be disposed with their major axes at four or more different angles with respect to a basis direction, for example a row direction of the pixels defined by the pixel defining layer, especially a horizontal direction of the display device. The major axis angles of the first openings or second openings can be arranged at intervals of 45 degrees or less. That is, the at least four or more different angles differ from each other by the mentioned interval, for example 45 degrees or less.

The oval shape may have an eccentricity of 0.2 to 0.85.

A first opening among the plurality of first openings and a second opening, which overlaps the first opening in the plan view, among the plurality of second openings may have a horizontal gap of more than 0 µm and less than or equal to 20 µm.

The oval shape may have a planar shape that merges portions of at least two oval shapes with different eccentricities in the plan view.

The oval shape may have a planar shape formed by cutting a first ellipse with a first eccentricity and a second ellipse with a second eccentricity in a first direction and then merging a cut portion of the first ellipse and a cut portion of the second ellipse.

In the light blocking area of the color filter, a blue color filter and a red color filter may overlap each other, and each of the plurality of second openings may overlap one of the blue color filter, the red color filter, and a green color filter.

The first opening may have the circular shape, the second opening of the color filter may have the oval shape, and borders of the first opening and the second opening may contact each other in the plan view.

The first opening may have the circular shape, the second opening of the color filter may have the oval shape, and the first opening may be located within the second opening in the plan view.

The first opening may have the circular shape, the second opening of the color filter may have the oval shape, a portion of the first opening may overlap the second opening in the plan view, and the rest of the first opening may overlap the light blocking area of the color filter in the plan view.

The first opening may have the oval shape, and the second opening of the color filter may have the circular shape.

According to embodiments, the openings of the pixel defining layer and/or the openings of the color filter may have an oval or a similar shape, the angles of the major axes of the ovals are arranged in various ways, the eccentricities of the ovals are formed in various ways, or the ovals are formed in a plurality of shapes. By having a merged structure that combines ellipses with eccentricity, color separation of external light can be effectively reduced or a constant diffraction pattern can be generated regardless of the angle.

According to embodiments, the diffraction pattern can be reduced by reducing the rate at which external light is reflected by using a black pixel defining layer instead of a polarizer to separate the light emitting layers from each other.

In addition, according to an embodiment, a plurality of color filters overlap without forming a black light blocking layer on the front of the display panel to prevent external light from being reflected or transmitted, thereby reducing the manufacturing process and manufacturing cost, while reducing diffraction patterns of external light or reducing color separation of external light.

### BRIEF DESCRIPTION OF THE DRAWINGS

FIG. 1 is a schematic perspective view illustrating a use state of a display device according to an exemplary embodiment.
FIG. 2 is an exploded perspective view of a display device according to an embodiment.
FIG. 3 is a block diagram of a display device according to an embodiment.
FIG. 4 is a perspective view schematically showing a light emitting display device according to another embodiment.
FIG. 5 is an enlarged plan view of a partial area of a light emitting display device according to an embodiment.
FIG. 6 is a schematic cross-sectional view of a display panel according to an embodiment.
FIG. 7 to FIG. 9 are plan views of a portion of a display panel according to embodiments.
FIG. 10 is a plan view of a portion of a display panel according to a comparative example.
FIG. 11 is a photograph of the reflection characteristics of the comparative example and the examples of FIGS. 7 to 9.
FIG. 12 is a diagram showing reflection characteristics of a light emitting display device depending on the angle.
FIG. 13 is a diagram showing various angle arrangements according to an embodiment.
FIG. 14 is a photograph of reflection characteristics according to angle.
FIGS. 15 and 16 are diagrams showing reflection characteristics according to eccentricity.
FIGS. 17 and 18 are diagrams showing a structure merging ellipses with different eccentricities.
FIG. 19 is a diagram showing a merged elliptical structure and its reflection characteristics according to an embodiment.
FIG. 20 is a plan view of a portion of a display panel according to another embodiment.
FIGS. 21 and 22 are diagrams showing reflection characteristics according to eccentricity.
FIG. 23 to FIG. 25 are plan views of a portion of a display panel according to another embodiment.
FIG. 26 is a plan view showing the configuration of a unit pixel of one of the display panels according to an embodiment.
FIG. 27 and FIG. 28 are plan views of a portion of a display panel according to another embodiment.
FIG. 29 is a photograph of the reflection characteristics of the comparative example and the example of FIG. 28.
FIG. 30 is a plan view of a portion of the display panel of the embodiment of FIG. 7 arranged at various angles.
FIG. 31 and FIG. 32 are plan views of a portion of a display panel according to another embodiment.
FIG. 33 and FIG. 34 are plan views of a portion of a display panel according to another embodiment.
FIG. 35 is a photograph of the reflection characteristics of the comparative example and the example of FIG. 34.
FIG. 36 and FIG. 37 are plan views of a portion of a display panel according to another embodiment.
FIG. 38 is a diagram showing a structure merging ellipses with different eccentricities.
FIG. 39 is a diagram showing a merged elliptical structure and its reflection characteristics according to another embodiment.
FIG. 40 is a plan view of a portion of a display panel according to another embodiment.
FIG. 41 is an enlarged plan view of a partial area of a light emitting display device according to another embodiment.
FIG. 42 is a plan view of a portion of a display panel according to another embodiment.
FIG. 43 is a graph showing the transmittance according to the wavelength of the color filter.
FIG. 44 is a plan view of a portion of a display panel according to another embodiment.
FIG. 45 is a cross-sectional view of a light emitting display device according to another embodiment.

### DETAILED DESCRIPTION

Hereinafter, with reference to the attached drawings, various embodiments will be described in detail so that those skilled in the art can easily implement the present invention.

The invention may be implemented in many different forms and is not limited to the embodiments described herein.

In order to clearly explain the present invention, parts that are not relevant to the description are omitted, and identical or similar components are assigned the same reference numerals throughout the specification.

In addition, the size and thickness of each component shown in the drawings are shown arbitrarily for convenience of explanation, so the present invention is not necessarily limited to that which is shown.

In the drawings, the thickness is enlarged to clearly express various layers and areas.

And in the drawings, for convenience of explanation, the thicknesses of some layers and regions are exaggerated.

Additionally, when a part, such as a layer, membrane, region, plate, component, etc., is said to be "above" or "on" another part, this means not only when it is "directly above" another part, but also when there is another part in between.

Conversely, when a part is said to be "right on top" of another part, it means that there is no other part in between.

In addition, being "above" or "on" a reference part means being located above or below the reference part, and does not necessarily mean being located "above" or "on" it in the direction opposite to gravity.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

In addition, throughout the specification, when a part is said to "include" a certain element, this means that it may further include other elements, rather than excluding other elements, unless specifically stated to the contrary.

In addition, throughout the specification, when reference is made to "on a plane" (i.e., in a plan view), this means when the target portion is viewed from above (i.e., thickness direction (DR3) of the substrate 110), and when reference is made to "in cross-section," this means when a cross-section of the target portion is cut vertically and viewed from the side. In addition, "planar shape" means a shape of an object in a plan view.

In addition, throughout the specification, when "connected" is used, this does not mean only when two or more components are directly connected, but when two or more components are indirectly connected through other components, that they are physically connected or electrically connected, but also the case where each part, which is referred to by different names depending on location or function, is substantially connected to the others.

In addition, throughout the specification, when a portion such as a wiring, layer, film, region, plate, or component is said to "extend in the first or second direction," this does not mean only a straight shape extending in that direction, but also a structure that extends overall along the first or second direction, and also includes a structure that is bent at some part, has a zigzag structure, or has a curved structure.

In addition, electronic devices (e.g., mobile phones, TVs, monitors, laptop computers, etc.) containing display devices, display panels, etc. described in the specification, or display devices, display panels, etc. manufactured by the manufacturing method described in the specification are not excluded from the scope of rights of this specification.

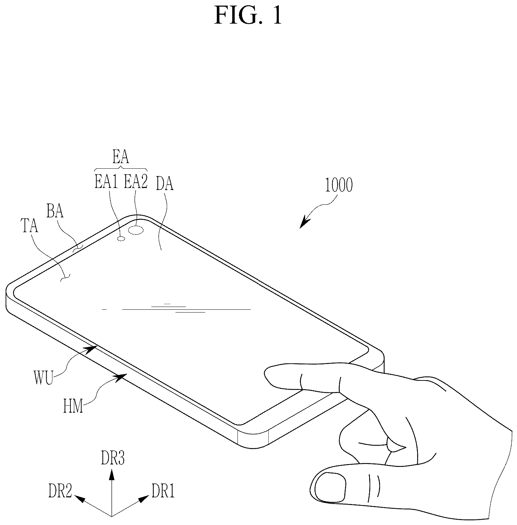

Below, the schematic structure of the display device through FIGS. 1 to 3 will be explained.

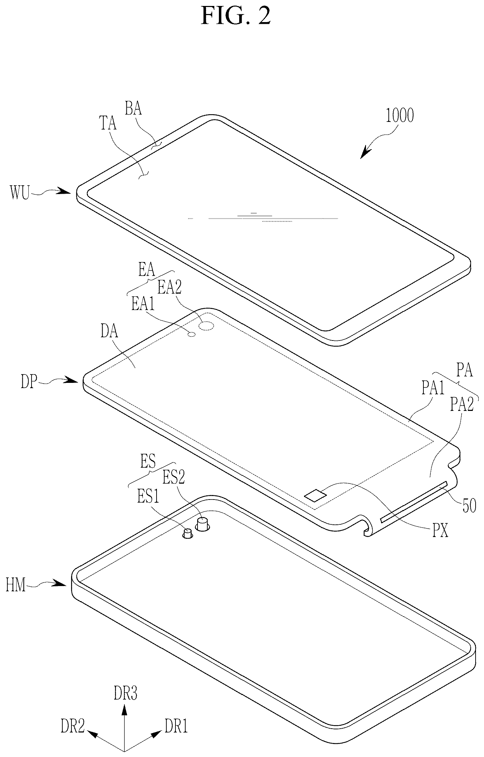

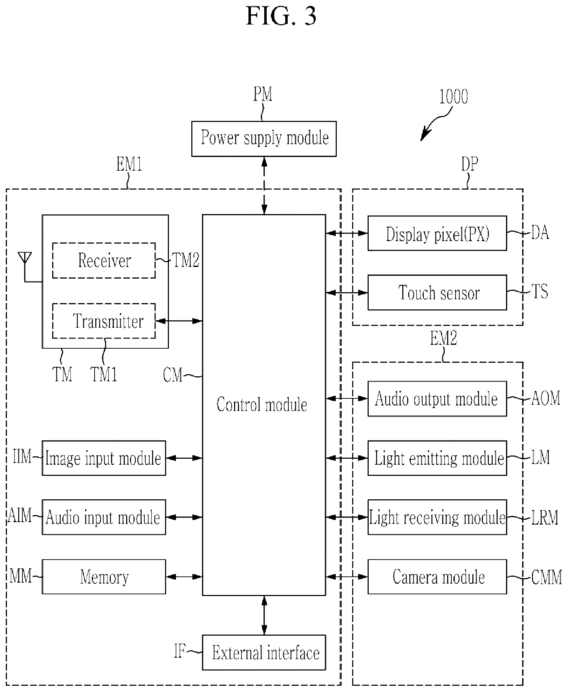

FIG. 1 is a schematic perspective view showing a use state of a display device according to an embodiment, FIG. 2 is an exploded perspective view of a display device according to an embodiment, and FIG. 3 is a block diagram of a display device according to an embodiment.

FIG. 1 is a schematic perspective view showing a use state of a display device according to an embodiment, FIG. 2 is an exploded perspective view of a display device according to an embodiment, and FIG. 3 is a block diagram of a display device according to an embodiment.

Referring to FIG. 1, a display device 1000 according to an embodiment is a device that displays moving images or still images, and may be used in a mobile phone, a smart phone, a tablet personal computer, or a mobile phone. It can be used as a display screen for portable electronic devices such as communication terminals, electronic notebooks, e-books, portable multimedia player ("PMP"), navigation, ultra mobile PC ("UMPC"), as well as televisions, laptops, monitors, billboards, internet of things ("IOT"), etc.

In addition, the display device 1000 according to an embodiment is mounted on a wearable device such as a smart watch, a watch phone, a glasses-type display, and a head-mounted display HMD.

Additionally, the display device 1000 according to an embodiment can be used as a car's dashboard, a center information display ("CID") placed on the car's center fascia or dashboard, a room mirror display replacing the car's side mirror, or a display placed on the back of the front seat for rear-seat entertainment in the car.

FIG. 1 shows the display device 1000 being used as a smart phone for convenience of explanation.

The display device 1000 may display an image in a third direction DR3 on a display surface parallel to each of a first direction DR1 and a second direction DR2.

The display surface on which the image is displayed may correspond to the front surface of the display device 1000 and the front surface of a cover window WU.

Images may include static images as well as dynamic images.

In this embodiment, the front (or top) and back (or bottom) surfaces of each member are defined based on the direction in which the image is displayed.

The front and back surfaces are opposed to each other in the third direction DR3, and the normal directions of each of the front and back surfaces may be parallel to the third direction DR3.

The separation distance between the front and back surfaces in the third direction DR3 may correspond to the thickness of the display panel in the third direction DR3.

The display device 1000 according to one embodiment may detect a user's input (refer to the hand in FIG. 1) applied from the outside.

The user's input may include various types of external inputs, such as parts of the user's body, light, heat, or pressure.

In one embodiment, the user's input is shown with the user's hand applied to the front.

However, the present invention is not limited to this.

The user's input may be provided in various forms, and the display device 1000 may also detect the user's input applied to the side or back of the display device 1000 depending on the structure of the display device 1000.

Referring to FIGS. 1 and 2, the display device 1000 may include a cover window WU, a housing HM, a display panel DP, and an optical element ES.

In one embodiment, the cover window WU and the housing HM may be merged to form the exterior of the display device 1000.

The cover window WU may include an insulating panel.

For example, the cover window WU may be made of glass, plastic, or a combination thereof.

The front of the cover window WU may define the front of the display device 1000.

A transmission area TA may be an optically transparent area.

For example, the transmission area TA may be an area with a visible light transmittance of about 90% or more.

A blocking area BA may define the shape of the transmission area TA.

The blocking area BA is adjacent to the transmission area TA, and may surround the transmission area TA.

The blocking area BA may be an area with relatively low light transmittance compared to the transmission area TA.

The blocking area BA may include an opaque material that blocks light.

The blocking area BA may have a predetermined color.

The blocking area BA may be defined by a bezel layer provided separately from the transparent substrate defining the transmission area TA, or may be defined by an ink layer formed by inserting or coloring the transparent substrate.

The display panel DP may include a display pixel PX that displays an image and a driver 50, and the display pixel PX is located in the display area DA and a component area EA.

The display panel DP may include a front surface including a display area DA and a peripheral area PA.

In one embodiment, the display area DA and the component area EA are areas where images are displayed including pixels, and at the same time, a touch sensor may be located in the upper direction of the third direction DR3 of the pixels, which can be an area where external inputs are detected.

The transmission area TA of the cover window WU may at least partially overlap the display area DA and the component area EA of the display panel DP.

For example, the transmission area TA may overlap the front surface of the display area DA and the component area EA, or may overlap at least a portion of the display area DA and the component area EA.

Accordingly, the user can view the image through the transmission area TA or provide external input based on the image.

However, the present invention is not limited to this.

For example, the area where the image is displayed and the area where external input is detected may be separated from each other.

A peripheral area PA of the display panel DP may at least partially overlap the blocking area BA of the cover window WU.

The peripheral area PA may be an area covered by the blocking area BA.

The peripheral area PA is adjacent to the display area DA and may surround the display area DA.

An image is not displayed in the peripheral area PA, and a driving circuit or driving wiring for driving the display area DA may be disposed.

The peripheral area PA may include a first peripheral area PA1 located outside the display area DA and a second peripheral area PA2 including the driver 50, connection wiring, and a bending area.

In the embodiment of FIG. 2, the first peripheral area PA1 is located on the third side of the display area DA, and the second peripheral area PA2 is located on the remaining side of the display area DA.

In one embodiment, the display panel DP may be assembled in a flat state with the display area DA, the component area EA, and the peripheral area PA facing the cover window WU.

However, the present invention is not limited to this.

A portion of the peripheral area PA of the display panel DP may be curved.

At this time, part of the peripheral area PA is directed toward the rear of the display device 1000, so that the blocking area BA visible on the front of the display device 1000 can be reduced, and in FIG. 2, the second peripheral area PA2 can be bent and placed on the back of the display area DA and then assembled.

Additionally, the component area EA of the display panel DP may include a first component area EA1 and a second component area EA2.

The first component area EA1 and the second component area EA2 may be at least partially surrounded by the display area DA.

The first component area EA1 and the second component area EA2 are shown spaced apart from each other, but are not limited to this and may be at least partially connected.

The first component area EA1 and the second component area EA2 may be areas in which an optical element (see ES in FIG. 2; hereinafter referred to as a component) that uses infrared rays, visible rays, or sound is disposed.

The display area (DA; hereinafter also referred to as the main display area) and the component area EA are formed with a plurality of light emitting diodes and a plurality of pixel circuit portions that generate and transmit light emission current to each of the plurality of light emitting diodes.

Here, one light emitting diode and one pixel circuit part are called a pixel PX.

One pixel circuit portion and one light emitting diode may be formed in a one-to-one ratio in the display area DA and the component area EA.

The first component area EA1 may include a transparent portion through which light and/or sound can pass and a display portion including a plurality of pixels.

The transmission portion is located between adjacent pixels and is composed of a layer through which light and/or sound can pass.

The transmission portion may be located between adjacent pixels, and depending on the embodiment, a layer that does not transmit light (e.g., visible light) of a specific wavelength may overlap the first component area EA1.

The number of pixels (hereinafter referred to as resolution) per unit area of the pixels (hereinafter referred to as normal pixels) included in the display area DA and the pixels included in the first component area EA1 (hereinafter referred to as first component pixels) per unit area may be the same.

The second component area EA2 includes an area composed of a transparent layer so that light can pass through (hereinafter also referred to as a light transmission area), and the light transmission area does not have a conductive layer or a semiconductor layer and includes a light blocking material-for example, a pixel defining layer and/or at least two color filters, may be formed to include an opening that overlaps a position corresponding to the second component area EA2 and may have a structure that does not block light.

The number of pixels per unit area of the pixels included in the second component area EA2 (hereinafter also referred to as second component pixels) may be smaller than the number of pixels per unit area of the normal pixels included in the display area DA.

As a result, the resolution of the second component pixel may be lower than that of the normal pixel.

Referring to FIG. 3, the display panel DP may further include a touch sensor TS in addition to the display area DA including the display pixels PX.

The display panel DP includes pixels PX, which are components that generate an image, and can be visible to the user from the outside through the transmission area TA.

Additionally, the touch sensor TS may be located on top of the pixel PX and may detect an external input.

The touch sensor TS can detect an external input provided to the cover window WU.

Referring again to FIG. 2, the second peripheral area PA2 may include a bending portion.

The display area DA and the first peripheral area PA1 may have a flat state substantially parallel to the plane defined by the first direction DR1 and the second direction DR2, and one side of the second peripheral area PA2 may be extended from a flat state to pass through a bending portion, and then be in a flat state again.

As a result, at least a portion of the second peripheral area PA2 may be bent and assembled to be located on the rear side of the display area DA.

When at least a portion of the second peripheral area PA2 is assembled, it overlaps the display area DA on a plane, so the blocking area BA of the display device 1000 may be reduced.

However, the present invention is not limited to this.

For example, the second peripheral area PA2 may not be bent.

The driver 50 may be mounted on the second peripheral area PA2, on the bending part, or mounted on one of both sides of the bending part.

The driver 50 may be provided in the form of a chip.

The driver 50 is electrically connected to the display area DA and the component area EA, and can transmit electrical signals to pixels in the display area DA and the component area EA.

For example, the driver 50 may provide data signals to the pixels PX arranged in the display area DA.

Alternatively, the driver 50 may include a touch driving circuit and may be electrically connected to the touch sensor TS disposed in the display area DA and/or the component area EA.

Meanwhile, the driver 50 may include various circuits in addition to the above-described circuits or may be designed to provide various electrical signals to the display area DA.

Meanwhile, the display device 1000 may have a pad portion located at an end of the second peripheral area PA2, and is electrically connected to a flexible printed circuit board FPCB including a driving chip by the pad portion.

Here, the driving chip located on the flexible printed circuit board may include various driving circuits for driving the display device 1000 or a connector for power supply.

Depending on the embodiment, a rigid printed circuit board PCB may be used instead of a flexible printed circuit board.

An optical element ES may be disposed below the display panel DP.

The optical element ES may include a first optical element ES1 overlapping the first component area EA1 and a second optical element ES2 overlapping the second component area EA2.

The first optical element ES1 may use infrared rays, and in this case, the first component area EA1 may be a layer that does not transmit light, such as visible light, and overlap the first component area EA1.

The first optical element ES1 may be an electronic element that uses light or sound.

For example, the first optical element ES1 is a sensor that receives and uses light such as an infrared sensor, a sensor that outputs and detects light or sound to measure distance or recognize a fingerprint, etc., a small lamp that outputs light, or it may be a speaker that outputs sound, etc.

In the case of electronic elements that use light, it goes without saying that light of various wavelength bands, such as visible light, infrared light, and ultraviolet light, can be used.

The second optical element ES2 is at least one of a camera, an IR camera, a dot projector, an IR illuminator, and a time-of-flight sensor.

Referring to FIG. 3, the display device 1000 may include a display panel DP, a power supply module PM, a first electronic module EM1, and a second electronic module EM2.

The display panel DP, the power supply module PM, the first electronic module EM1, and the second electronic module EM2 may be electrically connected to each other.

FIG. 3 illustrates display pixels and a touch sensor TS located in the display area DA among the configuration of the display panel DP.

The power supply module PM can supply power required for the overall operation of the display device 1000.

The power supply module PM may include a conventional battery module.

The first electronic module EM1 and the second electronic module EM2 may include various functional modules for operating the display device 1000.

The first electronic module EM1 may be mounted directly on the motherboard electrically connected to the display panel DP, or may be mounted on a separate board and electrically connected to the motherboard through a connector (not shown).

The first electronic module EM1 may include a control module CM, a wireless communication module TM, an image input module IIM, an audio input module AIM, a memory MM, and an external interface IF.

Some of the modules may not be mounted on the motherboard, but may be electrically connected to the motherboard through a flexible printed circuit board connected thereto.

The control module CM may control the overall operation of the display device 1000.

The control module CM may be a microprocessor.

For example, the control module CM activates or deactivates the display panel DP.

The control module CM can control other modules, such as the image input module IIM or the audio input module AIM, based on the touch signal received from the display panel DP.

A wireless communication module TM can transmit/receive wireless signals to and from other terminals using a Bluetooth or Wi-Fi line.

The wireless communication module TM can transmit/receive voice signals using a general communication line.

The wireless communication module TM includes a transmitter TM1 that modulates and transmits a signal to be transmitted, and a receiver TM2 that demodulates the received signal.

The image input module IIM can process video signals and convert them into video data that can be displayed on the display panel DP.

The audio input module AIM can receive external audio signals through a microphone in recording mode, voice recognition mode, etc. and convert them into electrical voice data.

An external interface IF may serve as an interface connected to an external charger, wired/wireless data port, card socket (e.g., memory card, SIM/UIM card), etc.

The second electronic module EM2 may include an audio output module AOM, a light emitting module LM, a light receiving module LRM, and a camera module CMM, at least some of which include optical elements ES. It may be located on the back of the display panel DP, as shown in FIGS. 1 and 2.

The optical element ES may include a light emitting module LM, a light receiving module LRM, and a camera module CMM.

In addition, the second electronic module EM2 is mounted directly on the motherboard, is mounted on a separate board and is electrically connected to the display panel DP through a connector (not shown), or is connected to the first electronic module EM1.

An audio output module AOM can convert audio data received from the wireless communication module TM or audio data stored in the memory MM and output it to the outside.

The light emitting module LM can generate and output light.

The light emitting module LM can output infrared rays.

For example, the light emitting module LM may include an LED device.

For example, a light receiving module LRM can detect infrared light.

The light receiving module LRM may be activated when infrared rays above a certain level are detected.

The light receiving module LRM may include a CMOS sensor.

After the infrared light generated in the light emitting module LM is output, it is reflected by an external subject (e.g., a user's finger or face), and the reflected infrared light may be incident on the light receiving module LRM.

The camera module CMM can capture external images.

In one embodiment, the optical element ES may additionally include a light detection sensor or a heat detection sensor.

The optical element ES can detect an external subject received through the front or provide a sound signal such as voice through the front to the outside.

Additionally, the optical element ES may include a plurality of components and is not limited to any one embodiment.

Again, referring to FIG. 2, a housing HM may be merged with the cover window WU.

The cover window WU may be disposed on the front of the housing HM.

The housing HM can be merged with the cover window WU to provide a predetermined accommodation space.

The display panel DP and the optical element ES may be accommodated in a predetermined accommodation space provided between the housing HM and the cover window WU.

The housing HM may include a material with relatively high rigidity.

For example, the housing HM may include a plurality of frames and/or plates made of glass, plastic, or metal, or a combination thereof.

The housing HM can stably protect the components of the display device 1000 accommodated in the internal space from external shock.

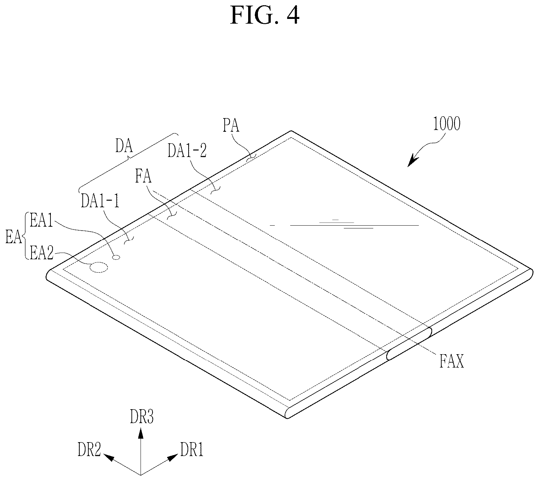

Hereinafter, the structure of the display device 1000 according to another embodiment will be looked at through FIG. 4.

FIG. 4 is a perspective view schematically showing a light emitting display device according to another embodiment.

Descriptions of the same components as those described above will be omitted, and the embodiment of FIG. 4 shows a foldable display device in which the display device 1000 is folded through a folding axis FAX.

Referring to FIG. 4, in one embodiment, the display device 1000 may be a foldable display device.

The display device 1000 may be folded outward or inward based on the folding axis FAX.

When folded outward based on the folding axis FAX, the display surfaces of the display device 1000 are positioned on the outside in the third direction DR3 so that images can be displayed in both directions.

If it is folded inward based on the folding axis FAX, the display surface may not be visible from the outside.

In one embodiment, the display device 1000 may include a display area DA, a component area EA, and a peripheral area PA.

The display area DA may be divided into a 1-1 display area DA1-1, a 1-2 display area DA1-2, and a folding area FA.

The first display area DA1-1 and the second display area DA1-2 may be located on the left and right sides, respectively, based on (or centered on) the folding axis FAX, and the folding area FA may be located between the first display area DA1-1 and the second display area DA1-2.

At this time, when folded outward based on the folding axis FAX, the first display area DA1-1 and the second display area DA1-2 are located on both sides in the third direction DR3, and this allows images to be displayed in both directions.

Additionally, when folded inward based on the folding axis FAX, the first display area DA1-1 and the second display area DA1-2 may not be visible from the outside.

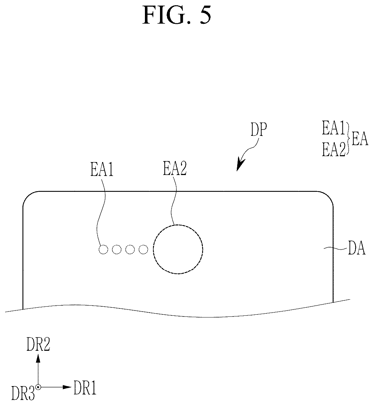

FIG. 5 is an enlarged plan view of a partial area of a light emitting display device according to an embodiment.

FIG. 5 shows a portion of a light emitting display panel DP of a light emitting display device according to an embodiment, and is shown using a display panel for a mobile phone.

The display area DA is located on the front of the light emitting display panel DP, and the component area EA is also located within the display area DA.

Specifically, the component area EA may include the first component area EA1 and the second component area EA2.

Additionally, in the embodiment of FIG. 5, the first component area EA1 is located adjacent to the second component area EA2.

In the embodiment of FIG. 5, the first component area EA1 is located to the left of the second component area EA2.

The location and number of the first component areas EA1 may vary depending on the embodiment.

In FIG. 5, the second optical element ES2 corresponding to the second component area EA2 may be a camera, and the first optical element ES1 corresponding to the first component area EA1 may be an optical sensor.

The display area DA is formed with a plurality of light emitting diodes and a plurality of pixel circuit portions that generate and transmit light emitting current to each of the plurality of light emitting diodes.

Here, one light emitting diode and one pixel circuit portion are called a pixel (PX).

In the display area DA, one pixel circuit portion and one light emitting diode are formed in a one-to-one arrangement.

The display area DA is hereinafter also referred to as the "normal display area."

Although the structure of the light emitting display panel DP below the cutting line is not shown in FIG. 5, the display area DA may be located below the cutting line.

The light emitting display panel DP according to the embodiment can be largely divided into a lower panel layer and an upper panel layer.

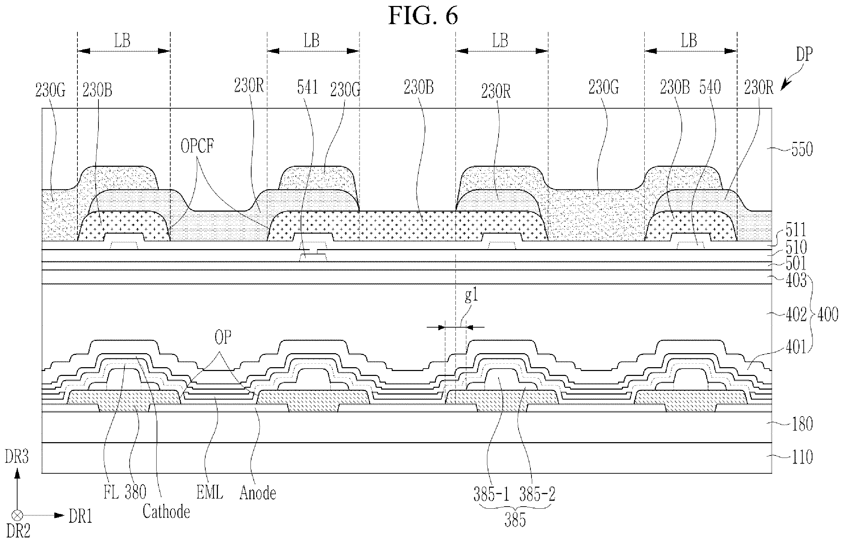

The lower panel layer is the part where the light emitting diode and the pixel circuit part that make up the pixel are located, and may even include an encapsulation layer (see 400 in FIG. 6) covering it.

That is, the lower panel layer consists of an anode, a pixel defining layer (see 380 in FIG. 6), a light emitting layer (see EML in FIG. 6), and a spacer (see 385 in FIG. 6) from the substrate (see 110 in FIG. 6) to the encapsulation layer, and it also includes a functional layer (see FL in FIG. 6), a cathode (see Cathode in FIG. 6), and an insulating layer between the substrate and anode, a semiconductor layer, and a conductive layer.

Meanwhile, the upper panel layer is a part located above the encapsulation layer and includes a sensing insulating layer (see 501, 510, and 511 in FIG. 6) and a plurality of sensing electrodes (see 540 and 541 in FIG. 6) capable of detecting touch, and it may include a color filter (see 230R, 230G, and 230B in FIG. 6), a planarization layer (see 550 in FIG. 6), and the like.

The first component area EA1 can be composed only of transparent layers that allow light to penetrate, and it may not have a conductive layer or a semiconductor layer in order to allow light to pass through. It may have a light sensor area on the lower panel layer, and on the shading area of the color filter, where the pixel defining layer of the upper panel layer and at least two or more color filters are overlapped, an opening (also referred to as an additional opening) can be formed at a position corresponding to the first component area EA1, so it can have a structure that does not block light.

Meanwhile, even if the optical sensor area is located in the lower panel layer, if there is no corresponding opening in the upper panel layer, it may be the display area DA rather than the first component area EA1.

One first component area EA1 may include a plurality of adjacent optical sensor areas, and in this case, pixels adjacent to the optical sensor area may be included in the first component area EA1.

Meanwhile, when the first optical element ES1 corresponding to the first component area EA1 uses infrared rays rather than visible rays, the first component area EA1 may have at least two color filters that block overlapping visible rays, and it can overlap a light blocking area of the existing color filter.

The second component area EA2 may include a second component pixel and a light transmission area, and the space between the adjacent second component pixels may be a light transmission area.

Although not shown in FIG. 5, a peripheral area may be further located outside the display area DA.

In addition, although FIG. 5 shows a display panel for a mobile phone, this embodiment can be applied to any display panel in which optical elements can be located on the back of the display panel, and it can also be a flexible display device.

In the case of a foldable display device among flexible display devices, the second component area EA2 and the first component area EA1 may be formed in positions different from those of FIG. 5.

Hereinafter, the structure of the light emitting display panel DP according to an embodiment will be described with reference to FIG. 6.

FIG. 6 is a schematic cross-sectional view of a display panel according to an embodiment.

The light emitting display panel DP according to one embodiment can display an image using a light emitting diode and color filters on a substrate 110, can detect a touch by including a plurality of sensing electrodes 540 and 541, and can also generate a light with a color characteristic of the color filter 230R, 230G, 230B by disposing a color filter 230R, 230G, 230B on the light emitting diode.

In the embodiment, a light blocking layer that has a black color and blocks visible light may not be formed, and instead of the light blocking layer, at least two color filters may be overlapped to block visible light.

The area where visible light is blocked by overlapping at least two color filters is referred to as the "light blocking area" of the color filter. In the embodiment of FIG. 6, the blue color filter 230B, the red color filter 230R, and the green color filter 230G are stacked sequentially.

The order in which the color filters are stacked may vary depending on the embodiment.

In addition, a polarizer is not formed on the front surface of the light emitting display panel DP according to one embodiment, and instead, the pixel defining layer 380 is formed of a black organic material, and at least two or more polarizers are formed on the upper part of the pixel defining layer 380. By forming a light blocking area LB of the color filters in which the color filters overlap, it is possible to prevent external light from being reflected from an anode or the like and transmitted to the user even if external light enters the interior.

A detailed look at the light emitting display panel DP according to an embodiment is as follows.

The substrate 110 may include a material that has rigid properties and does not bend, such as glass, or may include a flexible material that can bend, such as plastic or polyimide.

A plurality of thin film transistors are formed on the substrate 110, but are omitted in FIG. 6, and only the organic layer 180 covering the thin film transistors is shown.

One pixel is formed with a light emitting diode and a pixel circuit part in which a plurality of transistors and capacitors are formed to transmit light emitting current to the light emitting diode.

In FIG. 6, the pixel circuit portion is not shown, and the structure of the pixel circuit part may vary depending on the embodiment.

In FIG. 6, the organic layer 180 covering the pixel circuit part is shown first.

A light emitting diode including an anode, an EML, and a cathode is located on the organic layer 180.

An anode may be composed of a single layer containing a transparent conductive oxide film and a metal material or a multiple layer containing these.

The transparent conductive oxide film may include indium tin oxide ("ITO"), poly-ITO, indium zinc oxide ("IZO"), indium gallium zinc oxide ("IGZO"), and indium tin zinc oxide ("ITZO"), and the metal material may include silver (Ag), molybdenum (Mo), copper (Cu), gold (Au), and aluminum (Al).

A light emitting layer EML may be formed of an organic light emitting material, and adjacent light emitting layers EML may display different colors.

Meanwhile, depending on the embodiment, each light emitting layer EML may display light of the same color due to the color filters 230R, 230G, and 230B located at the top.

Depending on the embodiment, the light emitting layer EML may have a structure in which a plurality of light emitting layers are stacked (also called a tandem structure).

The pixel defining layer 380 is located on the organic layer 180 and the anode, an opening (OP; hereinafter referred to as a "first opening") is defined in the pixel defining layer 380, the first opening OP overlaps a part of the anode, and the light emitting layer EML overlaps a portion of the anode exposed by the first opening OP.

The light emitting layer EML can be located only within the first opening OP of the pixel defining layer 380 and is separated from the adjacent light emitting layer EML by the pixel defining layer 380.

The pixel defining layer 380 may be formed of a negative-type black organic material.

The black organic material may include a light blocking material, and the light blocking material may include carbon black, carbon nanotubes, a resin or paste containing black dye, metal particles such as nickel, aluminum, molybdenum, and alloys thereof, metal oxide particles (e.g., chromium nitride), and the like.

The pixel defining layer 380 contains a light blocking material and is black in color, and may have characteristics of absorbing/blocking light rather than reflecting it.

Because the negative type uses organic materials, it can have the property of removing the part covered by the mask.

A spacer 385 is formed on the pixel defining layer 380.

The spacer 385 includes a first part 385-1 that is located in a tall and narrow area, and a second part 385-2 that is located in a low, wide area.

In FIG. 6, the first part 385-1 and the second part 385-2 are shown separated by dotted lines within the spacer 385.

Here, the first part 385-1 may serve to secure rigidity against pressing pressure by enhancing scratch strength.

The second part 385-2 may serve to assist contact between the pixel defining layer 380 and the upper functional layer FL.

The first part 385-1 and the second part 385-2 are made of the same material, and may be made of a positive-type photosensitive organic material-for example, photosensitive polyimide PSPI.

Because it has positive characteristics, parts not covered by the mask can be removed.

The spacer 385 is transparent so that light can be transmitted and/or reflected.

The pixel defining layer 380 may be formed as a negative type, and the spacer 385 may be formed as a positive type. Depending on the embodiment, they may include the same materials.

At least a part of the upper surface of the pixel defining layer 380 is covered by the spacer 385, and the edge of the second part 385-2 has a structure in which the edge of the pixel defining layer 380 is spaced apart from the edge of the pixel defining layer 380, and a part of the pixel defining layer 380 has a structure that is not covered by the spacer 385.

The second part 385-2 covers even the upper surface of the pixel defining layer 380 where the first part 385-1 is not located, thereby strengthening the adhesion characteristics between the pixel defining layer 380 and the functional layer FL.

In this embodiment, the spacer 385 is located only in an area that overlaps the light blocking area LB of the color filter that blocks visible light by overlapping at least two color filters, so that when viewed from the front of the display panel DP, the spacer 385 may not be visible due to being obscured by the light blocking area LB of the color filter.

A functional layer FL is located on the spacer 385 and the exposed pixel defining layer 380, and the functional layer FL is formed on the entire surface of the light emitting display panel DP or in some areas. For example, the second component may be formed in all areas except the light transmitting area of the component area EA2.

The functional layer FL may include an electron injection layer, an electron transport layer, a hole transport layer, and a hole injection layer, and the functional layer FL may be located above and below the light emitting layer EML.

That is, the hole injection layer, the hole transport layer, the light emitting layer EML, the electron transport layer, the electron injection layer, and the cathode are located sequentially on the anode to form the hole injection layer and hole transport layer in the functional layer FL, the hole transfer layer may be located below the light emitting layer EML, and the electron transport layer and the electron injection layer may be located on top of the light emitting layer EML.

The spacer 385 can reduce the defect rate due to pressure by increasing the scratch resistance of the luminescent display panel DP, and according to the embodiment, it can increase the adhesion with the functional layer FL located on the upper part of the spacer 385 to prevent moisture and air from being injected from the outside.

In addition, high adhesive strength has the advantage of eliminating the problem of poor adhesion between layers when folded and unfolded if the light emitting display panel DP has flexible characteristics.

The cathode may be formed as a light transmitting electrode or a reflective electrode.

Depending on the embodiment, the cathode may be a transparent or translucent electrode, and may be lithium (Li), calcium (Ca), lithium/calcium fluoride (LiF/Ca), lithium/aluminum fluoride (LiF/Al), aluminum (Al), silver (Ag), magnesium (Mg), and their compounds can be formed as a metal thin film with a small work function.

Additionally, a transparent conductive oxide (TCO) film, such as indium tin oxide (ITO), indium zinc oxide (IZO), zinc oxide (ZnO), or indium oxide (In₂O₃), may be further disposed on the metal thin film.

The cathode may be formed integrally over the entire surface of the light emitting display panel DP.

An encapsulation layer 400 is located on the cathode.

The encapsulation layer 400 includes at least one inorganic layer and at least one organic layer, and in FIG. 6, it has a triple-layer structure including a first inorganic encapsulation layer 401, an organic encapsulation layer 402, and a second inorganic encapsulation layer 403.

The encapsulation layer 400 may be used to protect the light emitting layer EML made of an organic material from moisture or oxygen that may enter from the outside.

Depending on the embodiment, the encapsulation layer 400 may include a structure in which an inorganic layer and an organic layer are further sequentially stacked.

Sensing insulating layers 501, 510, and 511 and a plurality of sensing electrodes 540, 541 are positioned on the encapsulation layer 400 for touch detection.

In the embodiment of FIG. 6, touch is detected in a capacitive type using two sensing electrodes 540 and 541, but depending on the embodiment, touch can also be detected in a self-capacitive type using only one sensing electrode.

The plurality of sensing electrodes 540 and 541 may be insulated with a second sensing insulating layer 510 interposed therebetween, and a lower sensing electrode 541 is located on the first sensing insulating layer 501, and the second sensing insulating layer 510 is interposed between the plurality of sensing electrodes 540 and 541, an upper sensing electrode 540 is located on the layer 510, and the upper sensing electrode 540 is covered by a third sensing insulating layer 511.

The plurality of sensing electrodes 540 and 541 may be electrically connected through an opening located in the second sensing insulating layer 510.

Here, the sensing electrodes 540, 541 can include metals or metal alloys such as aluminum (Al), copper (Cu), silver (Ag), gold (Au), molybdenum (Mo), titanium (Ti), tantalum TA, and can be composed of a single layer or multiple layers.

Color filters 230R, 230G, and 230B are located on the third sensing insulating layer 511.

The color filters 230R, 230G, 230B include a red color filter 230R that allows red light to pass through, a green color filter 230G that allows green light to pass through, and a blue color filter 230B that allows blue light to pass through.

Each of the color filters 230R, 230G, and 230B may be positioned to overlap the anode of the light emitting diode on a plane.

Since the light emitted from the emitting layer EML may change to a corresponding color as it passes through a color filter, all light emitted from the emitting layer EML may have the same color.

However, the light emitting layer EML emits light of different colors, and the displayed color can be strengthened by passing through a color filter of the same color.

Depending on the embodiment, the color filters 230R, 230G, and 230B may be replaced with a color conversion layer or may further include a color conversion layer.

The color conversion layer may include quantum dots.

In the embodiment of FIG. 6, the light blocking layer that is black and blocks visible light is not formed, and instead of the light blocking layer, a light blocking area LB of a color filter formed by overlapping at least two color filters is formed to replace the light blocking layer.

In the embodiment of FIG. 6, the light blocking area LB of the color filter includes a blue color filter 230B, a red color filter 230R, and a green color filter 230G sequentially stacked.

The order in which the color filters are stacked may vary depending on the embodiment.

The light blocking area LB of the color filter where at least two or more color filters overlap may be positioned to overlap the sensing electrodes 540 and 541 in a plane, and may be positioned not to overlap the anode in a plane.

This is to ensure that the anode and the light emitting layer EML capable of displaying an image are not obscured by the light blocking area LB and the sensing electrodes 540 and 541 of the color filter.

Referring to FIG. 6, the light blocking area LB of the color filter where three color filters are overlapped is located only in the area overlapping the pixel defining layer 380, and one side of the light blocking area LB of the color filter is arranged inward from the corresponding side of the pixel defining layer 380.

Only one color filter can be located in an area excluding the light blocking area LB of the color filter, and light of the color of the corresponding color filter is transmitted to form a light transmitting area of the color filter.

Hereinafter, the light transmitting area of the color filter where only one color filter is located is referred to as a "second opening OPCF" of the color filter because light is transmitted, and the second opening OPCF is an area in which at least two or more color filters are overlapped, and an opening in a light blocking area LB can correspond to an area where only one color filter is located.

The area of the second opening OPCF is formed larger than the first opening OP of the pixel defining layer 380, and the first opening OP of the pixel defining layer 380 on the plane can be located within the second opening OPCF of the color filter.

In addition, one side of the spacer 385 is disposed inward at a predetermined distance g1 from the corresponding side of the pixel defining layer 380, and the spacer 385 is also disposed on one side of the light blocking area LB of the color filter.

As a result, when viewed from the front of the display panel DP, the spacer 385 may not be visible because it is obscured by the light blocking area LB of the color filter.

When external light is incident, it may pass through the second opening OPCF of the color filter and then be reflected on the side wall of the first opening OP of the pixel defining layer 380.

The side wall of the first opening OP of the pixel defining layer 380 is curved, and color separation occurs depending on the position of reflection, so that the reflected light can appear in various colors, such as a rainbow.

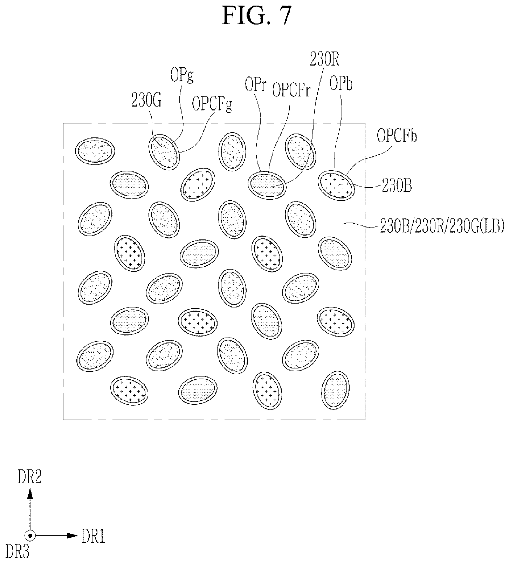

Since this color-separated reflected light can be easily seen by the user and deteriorate the display quality, in the embodiment, as in the embodiment of FIG. 7, the second opening OPCF of the color filter and the first opening OP of the pixel defining layer 380 have an oval shape, and the direction of the oval shape or the eccentricity of the oval shape is arranged in various ways to reduce color separation or allow white reflected light to be visually recognized.

Meanwhile, depending on the embodiment, it may be formed to have a shape similar to an oval rather than an oval, and its direction or eccentricity may be changed in various ways.

In this regard, this will be explained in more detail below.

A planarization layer 550 covering the color filters 230R, 230G, and 230B is positioned on the color filters 230R, 230G, and 230B.

The planarization layer 550 is used to planarize the upper surface of the light emitting display panel and may be a transparent organic insulating layer containing one or more materials selected from the group consisting of polyimide, polyamide, acrylic resin, benzocyclobutene, and phenol resin.

Depending on the embodiment, a low refractive layer and an additional planarization layer may be further positioned on the planarization layer 550 to improve front visibility and light output efficiency of the display panel.

Light can be refracted and emitted toward the front by the low refractive layer and the additional planarization layer with high refractive characteristics.

In this case, depending on the embodiment, the planarization layer 550 may be omitted and a low refractive layer and an additional planarization layer may be located directly on the color filter.

In this embodiment, a polarizer is not included on top of the planarization layer 550.

In other words, the polarizer can prevent display quality from deteriorating when external light is incident and reflected by the anode or the side wall of the first opening OP of the pixel defining layer 380, which is visible to the user.

However, the polarizer has the disadvantage of consuming more power to display a certain luminance by not only reducing the reflection of external light but also reducing the light emitted from the light emitting layer EML.

In order to reduce power consumption, the light emitting display device of this embodiment may not include a polarizer.

In addition, in this embodiment, the side of the anode is covered with the pixel defining layer 380 to reduce the degree of reflection from the anode, and a light blocking area LB of the color filter in which at least two or more color filters are overlapped is also formed to block the light. It includes a structure that reduces the amount of incident light and prevents deterioration of display quality due to reflection.

Therefore, there is no need to separately form the polarizer on the front of the light emitting display panel DP.

In the following, an embodiment in which the second opening OPCF of the color filter and the first opening OP of the pixel defining layer 380 are each formed in an elliptical shape through the structure of the light emitting display panel DP formed in the display area DA through FIGS. 7 to 9 will be explained.

FIG. 7 to FIG. 9 are plan views of a portion of a display panel according to embodiments.

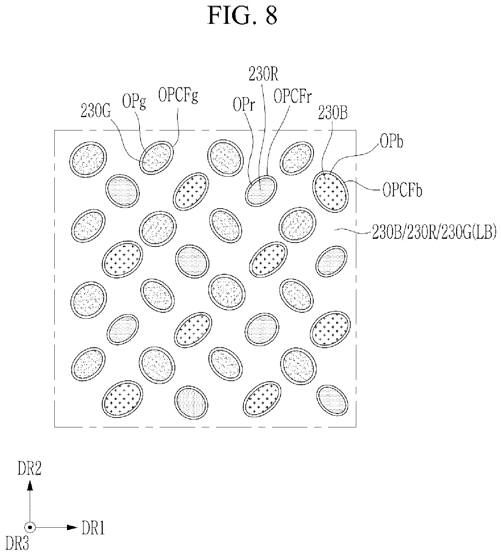

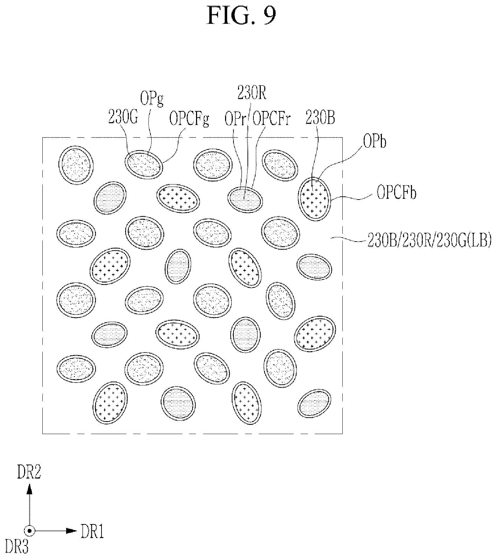

FIG. 7 to FIG. 9 each show different embodiments, and FIG. 7 shows an embodiment in which the second openings OPCF of the color filter and the first openings OP of the pixel defining layer 380 are arranged at various angles, FIG. 8 shows an embodiment in which the second openings OPCF of the color filter and the first openings OP of the pixel defining layer 380 are formed at various eccentricities, and FIG. 9 shows the second openings OPCF of the color filter and the first openings OP of the pixel defining layer 380 in an embodiment in which the first openings OP of the pixel defining layer 380 have various angles and are formed with various eccentricities.

In FIG. 7 to FIG. 9, the first openings OP of the pixel defining layer 380 and the second openings OPCF of the color filter corresponding to each light emitting layer are illustrated based on the light emitting layer for displaying the three primary colors of red, green, and blue, respectively, and they are distinguishably shown as a first openings OPr, OPg, OPb and second openings OPCFr, OPCFg, OPCFb.

Here, r, g, and b may correspond to red, green, and blue, respectively.

First, the planar structures of the first openings OPr, OPg, OPb of the pixel defining layer 380 and the second openings OPCFr, OPCFg, OPCFb of the color filter will be explained in detail through FIG. 7.

In FIG. 7, the first openings OPr, OPg, OPb of the pixel defining layer 380 and the second openings OPCFr, OPCFg, OPCFb of the color filter each have an elliptical planar shape with the same eccentricity.

That is, the red first opening OPr, the green first opening OPg, and the blue first opening OPb of the pixel defining layer 380 may all be ellipses with the same eccentricity.

Additionally, the red second opening OPCFr, the green second opening OPCFg, and the blue second opening OPCFb of the color filter may all be ellipses with the same eccentricity.

Here, the eccentricity of the first openings OPr, OPg, OPb of the pixel defining layer 380 and the second openings OPCFr, OPCFg, OPCFb of the color filter may have a value of 0.2 or more and 0.85 or less.

Here, the ellipse has two foci, can have a shape connecting points where the sum of the distances to the two foci is constant, and can have a major axis and a minor axis.

Meanwhile, the eccentricity of an ellipse is the distance between two foci divided by the length of the major axis.

When the eccentricity is 0, it is a circle, and when it is 1, it forms a parabola, so an ellipse has an eccentricity value that is greater than 0 and less than 1.

The first openings OPr, OPg, OPb of one pixel defining layer 380 correspond to the second openings OPCFr, OPCFg, OPCFb of one color filter.

That is, within each of the second openings OPCFr, OPCFg, OPCFb of the color filter, the first openings OPr, OPg, OPb of the pixel defining layer 380 correspond to each of the second openings OPCFr, OPCFg, OPCFb of the color filter.

The second openings OPCFr, OPCFg, OPCFb of the corresponding color filters and the first openings OPr, OPg, OPb of the pixel defining layer 380 may overlap each other on a plane, have a constant horizontal distance from each other, and have corresponding second openings OPCFr, OPCFg, OPCFb of the color filters. The second openings OPCFr, OPCFg, OPCFb of the two color filters and the first openings OPr, OPg, OPb of the pixel defining layer 380 may be formed in an elliptical shape with the major axes at the same angle.

Here, the horizontal interval between the second openings OPCFr, OPCFg, OPCFb of the color filter and the corresponding first openings OPr, OPg, OPb of the pixel defining layer 380 may be greater than 0 micrometer (µm) and less than or equal to 20 µm, and in the embodiment it may be 4.5 µm or more and 10 µm or less.

The horizontal gap between the second openings OPCFr, OPCFg, OPCFb of the color filter and the corresponding first openings OPr, OPg, OPb of the pixel defining layer 380 is a layer (for example, an encapsulation layer) located between the two in cross-section, the horizontal spacing may change depending on the thickness, and the encapsulation layer may have a thickness of about 6 µm.

Meanwhile, depending on the embodiment, the major axis directions of the second openings OPCFr, OPCFg, OPCFb of the corresponding color filter and the first openings OPr, OPg, OPb of the pixel defining layer 380 may form a certain angle due to process errors, etc., and can have an angle of 0 degrees or more and 20 degrees or less.

In the embodiment of FIG. 7, in the pixel defining layer 380 the multiple first openings OPr, OPg, OPb, can be disposed with their major axes at four or more different angles with respect to a basis direction, for example the first direction DR1. According to an exemplary embodiment, the major axis angles can be arranged at intervals of 45 degrees or less.

As an example, a specific angle relationship focusing on an embodiment with five angles is as follows.

The embodiment with five angles is formed with an interval of 36 degrees on the major axis, and in the case where one major axis has 0 degrees based on the first direction DR1, it has angles of 36 degrees, 72 degrees, 108 degrees, and 144 degrees, for a total of five angles.

In other words, the interval between the angles of the major axis can be checked by dividing the angle of 180 degrees by 5, which is the number of directions. This is because the two angles with an angle of 180 degrees out of 360 degrees have substantially the same direction of the major axis of the ellipse. This may mean calculating by dividing by the number based on 180 degrees.

Meanwhile, the major axes of the plurality of second openings OPCFr, OPCFg, OPCFb of the color filter may form four or more angles with respect to a basis direction, for example the first direction DR1, and the angles formed by the major axes may be arranged at intervals of 45 degrees or less.

As above, the plurality of first openings OPr, OPg, OPb of the pixel defining layer 380 or the plurality of second openings OPCFr, OPCFg, OPCFb of the color filter can be arranged at a specific angle of 45 degrees or less.

However, depending on the embodiment, the angles formed between two of the major axes of the openings may be 45 degrees or less and may be arranged at irregular intervals.

The embodiment in which the major axes of the openings are arranged at irregular intervals may be intentionally arranged to reduce the diffraction pattern, or may be arranged at irregular intervals due to processing errors.

In order for the unit pixel including the red, green, and blue openings to have a square structure, the angle of the major axis should be divided into numbers corresponding to the square of an integer -for example, 2², 3², 4², 5², etc.

Here, the unit pixel may include one each of red, green, and blue openings, and a plurality of openings of one color-for example, green openings-may be formed.

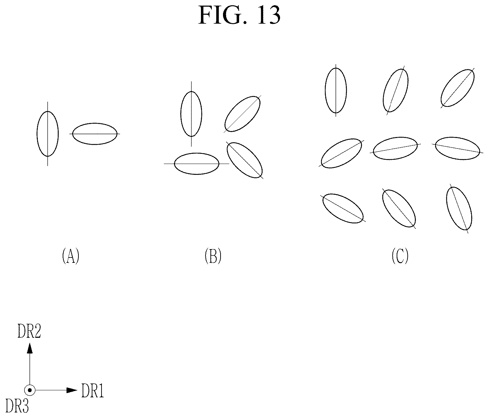

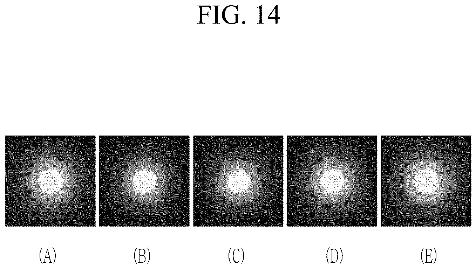

If the plurality of first openings OPr, OPg, OPb of the pixel defining layer 380 or the plurality of second openings OPCFr, OPCFg, OPCFb of the color filter are four or more or are arranged at intervals of less than 45 degrees, little color separation of external light occurs, or a certain diffraction pattern or color separation occurs regardless of the angle. This will be explained in more detail in FIGS. 13 and 14.

Meanwhile, the embodiment of FIG. 8 will be described below.

FIG. 8 shows an embodiment in which the second openings OPCFr, OPCFg, OPCFb of the color filter and the first openings OPr, OPg, OPb of the pixel defining layer 380 are formed in elliptical shapes with two or more different eccentricities.

Depending on the embodiment, each opening of the same color may be formed into an elliptical shape with an eccentricity of 2 or more and have a different elliptical shape.

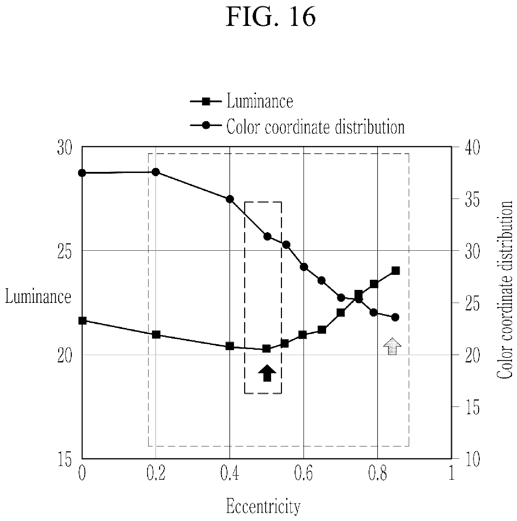

Here, referring to FIG. 16, the eccentricity of the oval shape may range from 0.2 to 0.85.

While in FIG. 8, the ellipses are disposed with their major axes in only two different directions forming an angle of 45 degrees with respect to the first direction DR1 or the second direction DR2, in another embodiment, the ellipses may be disposed with their major axes in four or fewer different directions depending on the embodiment.

Through FIG. 8, the planar structures of the first openings OPr, OPg, OPb of the pixel defining layer 380 and the second openings OPCFr, OPCFg, OPCFb of the color filter will be explained in detail.

In FIG. 8, the first openings OPr, OPg, OPb of the pixel defining layer 380 and the second openings OPCFr, OPCFg, OPCFb of the color filter have an elliptical planar shape and are arranged in the first direction DR1 or the second direction DR2, that is preferably along a linear line, the elliptical major axes are disposed in only two directions forming 45 degrees with respect to the second direction DR2.

Meanwhile, each of the red first opening OPr, green first opening OPg, and blue first opening OPb of the pixel defining layer 380 may be formed as an ellipse with at least two different eccentricities.

In addition, the red second opening OPCFr, the green second opening OPCFg, and the blue second opening OPCFb may each be formed as an ellipse with at least two different eccentricities.

In addition, in the embodiment of FIG. 8, the first openings OPr, OPg, OPb of the pixel defining layer 380 of the same color have at least two different elliptical planar shapes with different eccentricities. Also, the second openings OPCFr, OPCFg, OPCFb of the color filters of the same color may have at least two different eccentricities and thus have different elliptical planar shapes.

The first openings OPr, OPg, OPb of one pixel defining layer 380 correspond to the second openings OPCFr, OPCFg, OPCFb of one color filter.

That is, within each of the second openings OPCFr, OPCFg, OPCFb of the color filter are located the first openings OPr, OPg, OPb of the pixel defining layer 380 correspond to each of the second openings OPCFr, OPCFg, OPCFb of the color filter.

The second openings OPCFr, OPCFg, OPCFb of the corresponding color filters and the first openings OPr, OPg, OPb of the pixel defining layer 380 may overlap each other on a plane and have an elliptical shape with a certain horizontal distance from each other, and the major axis directions may be formed at the same angle.

Here, the horizontal interval between the second openings OPCFr, OPCFg, OPCFb of the color filter and the corresponding first openings OPr, OPg, OPb of the pixel defining layer 380 may be greater than 0 µm and less than or equal to 20 µm, and they may be 4.5 µm or more and 10 µm or less in some embodiments.

The horizontal gap between the second openings OPCFr, OPCFg, OPCFb of the color filter and the corresponding first openings OPr, OPg, OPb of the pixel defining layer 380 is a layer (for example, an encapsulation layer) located between the two in cross-section, and the horizontal spacing may change depending on the thickness.

Meanwhile, depending on the embodiment, the major axis directions of the second openings OPCFr, OPCFg, OPCFb of the corresponding color filter and the first openings OPr, OPg, OPb of the pixel defining layer 380 may form a certain angle due to process errors, etc., and can have an angle of 0 degrees or more and 20 degrees or less.

Although the opening is of the same color in the embodiment of FIG. 8, two or more oval shapes with different eccentricities may be placed in various positions at various proportions.

Depending on the embodiment, the same number of oval shapes with different eccentricities may be included in the display area, and depending on the embodiment, they may be included in different numbers.

For example, when the red first opening OPr of the pixel defining layer 380 is formed into two oval shapes with different eccentricities, the red second opening OPCFr of the corresponding color filter also has different eccentricities.

However, depending on the embodiment, the red second opening OPCFr of the color filter may be formed with the same eccentricity.

Referring to FIG. 8, if the angle formed by each major axis of the plurality of first openings OPr, OPg, OPb of the pixel defining layer 380 or the plurality of second openings OPCFr, OPCFg, OPCFb of the color filter is in the first direction, it forms an angle of 45 degrees with respect to the first direction DR1 and the second direction DR2.

In an embodiment in which the eccentricity of the ellipse is formed in various ways, unlike FIG. 7, the number of angles formed by the major axis of the ellipse may be four or less.

That is, in the embodiment of FIG. 8, various elliptical shapes with different eccentricities are formed in order to reduce color separation of external light or to generate a constant diffraction pattern or color separation regardless of angle.

Therefore, the embodiment of FIG. 8 enables constant color separation and/or constant diffraction in a different manner from the embodiment of FIG. 7 in which the major axis direction of the ellipse is varied.

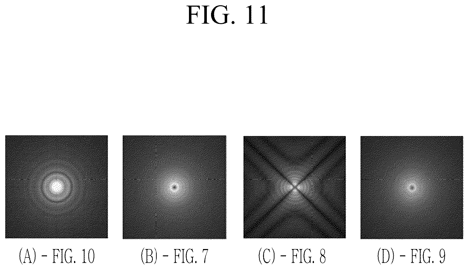

Meanwhile, in the embodiment of FIG. 8, the number of ellipses in the major axis direction is small, so a reflection diffraction pattern as shown in (C) of FIG. 11 can be generated, so a plurality of first openings OPr, OPg, OPb of the pixel defining layer 380 or the directionality of the diffraction pattern may be reduced by forming one of the plurality of second openings OPCFr, OPCFg, OPCFb of the color filter in a circular shape or by increasing the number of major axis directions in an elliptical shape.

Meanwhile, the following will look at the embodiment of FIG. 9. The embodiment of FIG. 9 combines the embodiment of FIG. 7 and the embodiment of FIG. 8.

In FIG. 9, the second openings OPCFr, OPCFg, OPCFb of the color filter and the first openings OPr, OPg, OPb of the pixel defining layer 380 are formed in an elliptical shape with different eccentricities even for the same color, the angles formed by the major axes of the second openings OPCFr, OPCFg, OPCFb of the color filter and of the first openings OPr, OPg, OPb of the pixel defining layer 380 are arranged at intervals of 45 degrees or less, or have four or more angles.

Here, referring to FIG. 16, the eccentricity of the oval shape may range from 0.2 to 0.85.

The embodiment of FIG. 9 includes all the features of the embodiment of FIG. 7 and the embodiment of FIG. 8, so that if multiple first openings OPr, OPg, OPb of the pixel defining layer 380 or multiple second openings OPCFr, OPCFg, OPCFb of the color filter have four or more, or are arranged at intervals of 45 degrees or less, additionally, the eccentricity of the ellipse is variably formed to cause less color separation of external light or to cause a constant diffraction pattern or color separation regardless of the angle.

Depending on the embodiment, the major axis directions of the plurality of first openings OPr, OPg, OPb of the pixel defining layer 380 or the plurality of second openings OPCFr, OPCFg, OPCFb of the color filter are formed at constant or irregular intervals.

A rough comparison of the embodiments of FIGS. 7 to 9 may be as shown in Table 1 below.

**[Table 1]**

| | FIG. 7 exemplary embodiment | FIG. 8 exemplary embodiment | FIG. 9 exemplary embodiment |
|---|---|---|---|
| eccentricity of the second opening ellipse of the color filter | red, green, blue same eccentricity | eccentricity equal to or more than 2different eccentricity by coloropening of the same color has a different eccentricity (A circle with an eccentricity of 0 is also possible.) | eccentricity equal to or more than 2 different eccentricity by color opening of the same color has a different eccentricity (A circle with an eccentricity of 0 is also possible.) |
| color filter second opening area (aperture ratio) arrange ratio | same equalization arrange | area varies depending on eccentricity total number of ellipses with different eccentricities is the same or different | Area varies depending on eccentricity total number of ellipses with different eccentricities is the same or different |
| Pixel defining layer opening ellipse major axis angle | Four or more angles | 2 angles of 45 degrees (Angles less than 4 are also possible.) | Can be arranged at equal to or more than 4 angles |
| second elliptical shape of the color filter's opening | pixel defining layer defined to be offset at a certain distance in the opening | pixel defining layer defined to be offset at a certain distance in the opening | pixel defining layer defined to be offset at a certain distance in the opening |

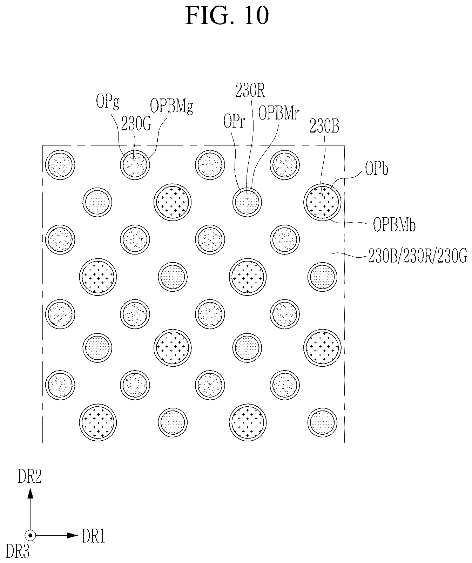

In order to examine the characteristics of the embodiment, the comparative example of FIG. 10 is explained, and the diffraction characteristics and color dispersion characteristics of reflected light between the comparative example and the example are compared and explained through FIG. 11.

FIG. 10 is a plan view of a portion of the display panel according to the comparative example, and FIG. 11 is a photograph of reflection characteristics of the comparative example and the examples of FIGS. 7 to 9.

The comparative example of FIG. 10, unlike the embodiments of FIGS. 7 to 9, has both the second opening OPCFr, OPCFg, OPCFb of the color filter and the first opening OPr, OPg, OPb of the pixel defining layer 380 formed in a circular shape.

Meanwhile, FIG. 11 shows the diffraction pattern and color dispersion of reflected light for the examples of FIGS. 7 to 9 and the comparative example of FIG. 10, with (A) of FIG. 11 being the comparative example of FIG. 10 and (B) of FIG. 11 is the embodiment of FIG. 7, (C) of FIG. 11 is the embodiment of FIG. 8, and (D) of FIG. 11 is the embodiment of FIG. 9.

First, looking at the comparative example of (A) of FIG. 11, the diffraction pattern is formed in a ring shape and is independent of the angle, but multiple rings are formed, and each ring shows a different color, so it can be confirmed that the reflected light is color-separated.

In contrast, referring to (B) and (D) of FIG. 11, the diffraction pattern has no directionality, so it has a diffraction pattern that is independent of the angle, and the ring shape is not recognized and appears white overall, so no specific color separation occurs.

Meanwhile, in (C) of FIG. 11, the diffraction pattern has a linear pattern at an angle of 45 degrees. This is caused by arranging the major axis angle of the ellipse only at 45 degrees. Therefore, the diffraction characteristics depending on the angle can be reduced by forming circular openings or increasing the number of directions of the major axes of the ellipses.

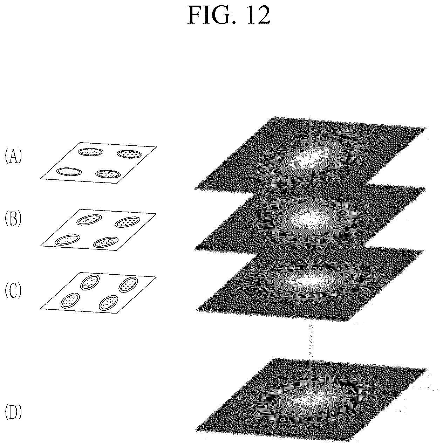

Below, the characteristics according to the major axis angle through FIGS. 12 to 14 will be explained.

First, the relationship between the major axis angle of the ellipse and the direction of the diffraction pattern of reflected light through FIG. 12 will be explained.

FIG. 12 is a diagram showing reflection characteristics of a light emitting display device depending on the angle.

The left side of (A), (B) and (C) of FIG. 12 shows a structure in which the opening of the pixel defining layer 380 and the second opening of the color filter are arranged in the same direction, and the diffraction pattern of reflected light is shown on the right side.

Referring to FIG. 12, when the opening of the pixel defining layer and the second opening of the color filter have an elliptical shape, the diffraction pattern of the reflected light is also formed in an elliptical shape, but it can be seen that the major axis directions are different from each other.

That is, the major axis direction of the opening of the pixel defining layer and the second opening of the color filter and the major axis direction of the elliptical pattern of the diffraction pattern of the reflected light may be perpendicular to each other.

When the diffraction patterns (A), (B), and (C) on the right side of FIG. 12 are merged, it becomes a circular diffraction pattern as shown in (D) of FIG. 12 below, showing that it is possible to have a diffraction pattern that is independent of the angle.

Hereinafter, through FIGS. 13 and 14, the number of elliptical structures arranged at various angles are needed to form a diffraction pattern that is independent of the angle will be explained.

FIG. 13 is a diagram showing various angle arrangements according to an embodiment, and FIG. 14 is a photograph of reflection characteristics according to angle.

First, FIG. 13 shows the major axis directions of one set of ellipses that can be formed in one display area.
(A) of FIG. 13 illustrates an example where the first opening OP of the pixel defining layer 380 or the second opening OPCF of the color filter has two major axis directions, and an example where two major axis directions are arranged at intervals of 90 degrees.
(B) of FIG. 13 illustrates an example where the first opening OP of the pixel defining layer 380 or the second opening OPCF of the color filter has four major axis directions, and an example where four major axis directions are arranged at intervals of 45 degrees.
(C) of FIG. 13 shows an embodiment where the first opening OP of the pixel defining layer 380 or the second opening OPCF of the color filter has nine major axis directions, and an embodiment where nine major axis directions are arranged at intervals of 20 degrees.

In addition to the major axis directions shown in FIG. 13, various other major axis directions arranged at various angles can be formed. If the number of major axis directions is small, differences in the diffraction pattern depending on the angle occur as shown in (C) of FIG. 11 and therefore, embodiments may include a certain number or more major axis angles.

To confirm this, FIG. 14 shows diffraction patterns according to the various number of major axis directions.
(A) of FIG. 14 is a diffraction pattern of an example with 4 major axis angles as in (B) of FIG. 13, (B) of FIG. 14 is a diffraction pattern of an example with 5 major axis angles, and (C) of FIG. 14 is a diffraction pattern of an example with 6 major axis angles, (D) of FIG. 14 is a diffraction pattern of an example with 7 major axis angles, and (E) of FIG. 14 is a diffraction pattern of an example with 8 major axis angles.

In order to have a diffraction pattern that is independent of direction in FIG. 14, it is better to have a diffraction pattern close to a circular shape, and in (A) of FIG. 14, it can be seen that the diffraction characteristics and color separation are different depending on the direction due to the protruding shape.

However, compared to the comparative example of (A) of FIG. 11, the diffraction pattern is not clear and is less visible than the comparative example.

Meanwhile, (B) and (E) of FIG. 14 have circular diffraction patterns and have diffraction characteristics and color separation independent of direction.

Therefore, based on FIG. 14, if the first opening OP of the pixel defining layer 380 or the second opening OPCF of the color filter is formed to have four or more major axis angles, a constant diffraction pattern or color is generated regardless of the angle, and separation may occur, improving display quality.

Referring to the above, it is possible to have four or more major axis angles, and in an embodiment having four or more major axis angles, the major axis angles may be arranged at intervals of 45 degrees or less.

In the above, the angles and number of angles between the angles of the major axis of the oval were explained.

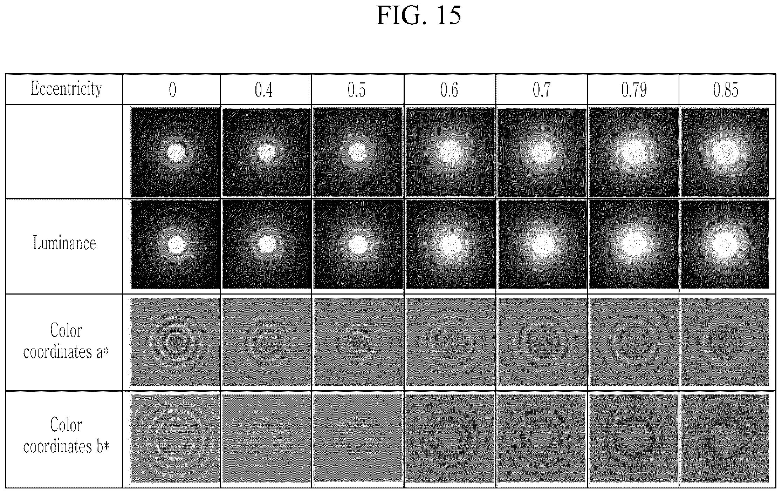

Below, based on FIGS. 15 and 16, changes in reflection characteristics according to changes in the eccentricity of the ellipse will be explained.

FIGS. 15 and 16 are diagrams showing reflection characteristics according to eccentricity.

FIG. 15 shows a diagram in which the luminance distribution and the dispersion on the two axes of color coordinates are extracted for the color diffraction pattern of reflected light according to the value of eccentricity. Based on this, FIG. 16 shows a graph of the standard deviation value of luminance based on the eccentricity and the distance values on color coordinates.

In FIGS. 15 and 16, it is seen that the smaller the distance value on the luminance distribution and color coordinates, the weaker the diffraction.

In FIG. 16, the position where the distance value on the luminance scale or color coordinates is the smallest is indicated by an arrow.

Referring to FIGS. 15 and 16, it can be seen that when the eccentricity is 0.5, it has the smallest luminance distribution value and is the best embodiment even considering color coordinate distribution.

Also, referring to FIG. 16, it is determined that in the area partitioned by the dotted line-that is, in the range of 0.2 to 0.85-the luminance distribution and color coordinate distribution do not significantly degrade the display quality, so an ellipse with such a range of eccentricity can be applied in this embodiment.

In the above, the first opening OP of the pixel defining layer 380 or the second opening OPCF of the color filter was explained with a focus on an embodiment in with one eccentricity.

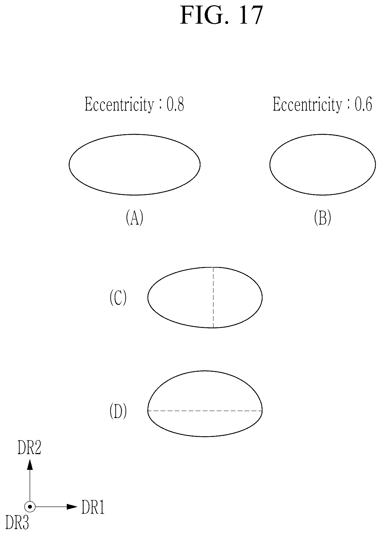

Depending on the embodiment, it may be formed in a shape similar to an ellipse-for example, at least two ellipse shapes with different eccentricities are merged to form a first opening OP of one pixel defining layer 380 or a second opening OPCF of a color filter, which will be explained in detail through FIGS. 17 to 19.

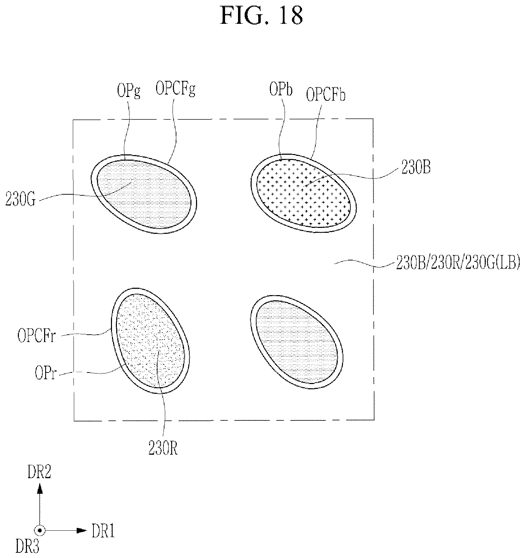

First, the basic oval shape and the arrangement of the openings based on it through FIGS. 17 and 18 will be explained.

FIGS. 17 and 18 are diagrams showing a structure merging ellipses with different eccentricities.

In FIG. 17, an example of merging two or more ellipse shapes with different eccentricities is explained in detail.

In (A) and (B) FIG. 17, ellipses with different eccentricities are depicted, and in (C) and (D) of FIG. 17, ellipses formed by merging two ellipses with different eccentricities in different ways are depicted.

In (A) of FIG. 17, an ellipse with an eccentricity of 0.8 is shown, and in (B) of FIG. 17, an ellipse shape with an eccentricity of 0.6 is shown.

An ellipse that merges these two ellipses may have a shape like (C) or (D) of FIG. 17.

In (C) and (D) of FIG. 17, a dotted line is shown within the merged oval shape, and the ovals on both sides of the dotted line are parts of an ellipse with different eccentricities.

That is, (C) of FIG. 17 is an example in which the ellipses of (A) and (B) of FIG. 17 are cut along the second direction DR2 and then combined, and (D) of FIG. 17 is an example in which the ellipses of (A) and (D) of FIG. 17 are cut along the first direction DR1 and then combined.

The method of merging two ellipses with different eccentricities is not limited to this and can be merged in various ways.

The second openings OPCFr, OPCFg, OPCFb of the color filter and the first openings OPr, OPg, OPb of the pixel defining layer 380 are opened in various major axis directions using a merged elliptical shape in the same manner as in (C) of FIG. 17. An example of the arrangement is shown in FIG. 18.

In the embodiment of FIG. 18, only one unit pixel is shown, and one unit pixel includes one red opening OPr, OPCFr, one blue opening OPb, OPCFb, and two green openings OPg, OPCFg.

In the embodiment of FIG. 18, the major axis directions of the first openings OPr, OPg, OPb of the pixel defining layer 380 may be different from each other, and the major axis directions of the second openings OPCFr, OPCFg, OPCFb of the color filter may also be different from each other.

As in FIG. 18, an embodiment using merged ellipses each with two different eccentricities, as explained in FIG. 14, may have different angles formed by the four or more major axes of the pixel defining layer 380's first openings OPr, OPg, OPb and the second openings of OPCFr, OPCFg, OPCFb of the color filter, respectively, and the angles formed by the major axes can be arranged at intervals of less than 45 degrees.

Additionally, the eccentricities of the two ellipses used for merging may vary, so the size of the merged ellipses may also vary.

Additionally, depending on the embodiment, two ovals with different eccentricities for each color can be merged, and even if they are the same color, two ovals with different eccentricities can be merged to form various ovals.

Here, the eccentricity of the first openings OPr, OPg, OPb of the pixel defining layer 380 and/or the second openings OPCFr, OPCFg, OPCFb of the color filter is 0.2 or more and 0.85 or less, as shown in FIGS. 15 and 16.

The major axis directions of the first openings OPr, OPg, OPb of the pixel defining layer 380 and the second openings OPCFr, OPCFg, OPCFb of the corresponding color filter may be the same or form an angle of less than 20 degrees due to process errors, etc.

Meanwhile, the first openings OPr, OPg, OPb of the pixel defining layer 380 and the second openings OPCFr, OPCFg, OPCFb of the corresponding color filter can have a constant interval on the plane or a horizontal interval of more than 0 micrometers and less than or equal to 20 micrometers.

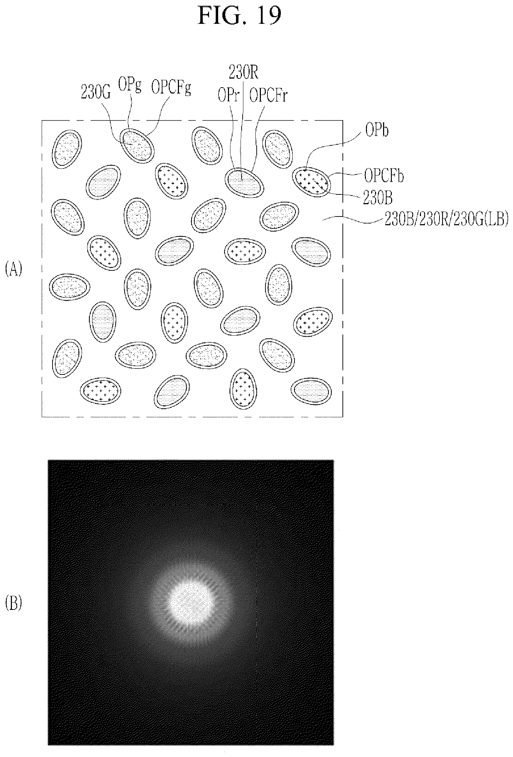

Below, the diffraction characteristics of reflected light for an example ((A) of FIG. 19) using an elliptical shape merged in the same manner as in (C) of FIG. 17 will be explained.

FIG. 19 is a diagram showing a merged elliptical structure and its reflection characteristics according to an embodiment.

(A) of FIG. 19 shows an embodiment in which the openings of each color have the same merged elliptical shape, but the major axis direction has four or more angles.

In (B) of FIG. 19, the diffraction characteristics of the reflected light in (A) of FIG. 19 are shown.

Compared to the comparative example of (A) of FIG. 11, it can be seen that the diffraction characteristic of (B) of FIG. 19 has a blurred reflection diffraction pattern, the ring shape is less clear, and it is not easy for a user to recognize the separated colors.

As a result, the example shown in (A) of FIG. 19 can also have improved display quality compared to the comparative example.

In the embodiments of FIGS. 17 to 19, the embodiments of merging two different elliptical shapes are shown and explained.

However, depending on the embodiment, it is also possible to merge two or more elliptical shapes with different eccentricities.

As described above, the embodiment of merging two or more oval shapes also has a reflection diffraction pattern with blurred diffraction characteristics similar to (B) of FIG. 19, so the ring shape is less clear, the user cannot easily recognize the separated colors, and it can have improved display quality compared to the example.

In addition, the elliptical shape of the first openings OPr, OPg, OPb of the pixel defining layer 380 and the elliptical shape of the second openings OPCFr, OPCFg, OPCFb of the corresponding color filter are spaced at a certain distance on the plane, and the spacing on the plane may vary depending on the location.

That is, depending on the embodiment, the number or eccentricity of the elliptical shapes merged with the elliptical shapes of the first openings OPr, OPg, OPb of the pixel defining layer 380 are determined by the second openings OPCFr, OPCFg, OPCFb of the corresponding color filter, and the number or eccentricity of the elliptical shapes merging with the elliptical shapes may be different.

As described above, even when the elliptical shape of the first openings OPr, OPg, OPb of the pixel defining layer 380 and the elliptical shape of the second openings OPCFr, OPCFg, OPCFb of the corresponding color filter are different from each other, they have a reflective diffraction pattern similar to a reflective diffraction pattern of (B) of FIG. 19 so the ring shape is less clear and the color separation is difficult for the user to easily recognize, resulting in improved display quality compared to the comparative example.

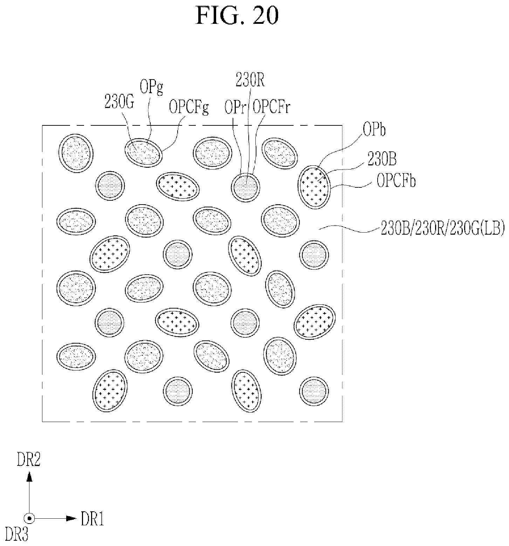

Meanwhile, depending on the embodiment, the openings of some colors may have a circular shape rather than an oval, and this embodiment will be explained with reference to FIG. 20.

FIG. 20 is a plan view of a portion of a display panel according to another embodiment.

FIG. 20 is based on the embodiment of FIG. 9, and the red first opening OPr of the pixel defining layer 380 and the red second opening OPCFr of the color filter have a circular shape rather than an oval shape.

That is, the green first opening OPg and blue first opening OPb of the pixel defining layer 380 and the green and blue second openings OPCFg, OPCFb of the color filter all have an oval shape.

Meanwhile, depending on the embodiment, one color in addition to red among the three-color openings may have a circular shape.

In other words, according to the embodiment, one or two of the red first opening OPr, green first opening OPg, and blue first opening OPb of the pixel defining layer 380 can have a circular shape, and the others can have an elliptical shape.

In addition, the red second opening OPCFr, the green second opening OPCFg, and the blue second opening OPCFb may each have a shape corresponding to the planar shape of the corresponding red first opening OPr, the green first opening OPg and the blue first opening OPb of the pixel defining layer 380, and the red second opening OPCFr, the green second opening OPCFg, and the blue second opening OPCFb may each have a certain horizontal distance from the corresponding red first opening OPr, the green first opening OPg and the blue first opening OPb of the pixel defining layer 380.

At this time, when the first openings OPr, OPg, OPb of the pixel defining layer 380 have an elliptical shape, the second openings OPCFr, OPCFg, OPCFb of the corresponding color filter also have an elliptical shape, and the corresponding second openings OPCFr, OPCFg, OPCFb have an elliptical shape. The first openings OPr, OPg, OPb of the pixel defining layer 380 and the second openings OPCFr, OPCFg, OPCFb of the color filter may have the same oval-shaped major axis direction.

In FIG. 20, as in the embodiment of FIG. 9, among the second openings OPCFr, OPCFg, OPCFb of the color filter and the first openings OPr, OPg, OPb of the pixel defining layer 380, the openings having an oval shape are formed in oval shapes with different eccentricities, and among the second openings OPCFr, OPCFg, OPCFb of the color filter and the first openings OPr, OPg, OPb of the pixel defining layer 380, the openings have an oval shape, the angles formed by each major axis may have four or more angles, or the angles formed by the major axes may be arranged at intervals of 45 degrees or less.

Here, the eccentricity of the oval shape may range from 0.2 to 0.85.

Depending on the embodiment, among the plurality of first openings OPr, OPg, OPb of the pixel defining layer 380 or the plurality of second openings OPCFr, OPCFg, OPCFb of the color filter, the elliptical major axis direction is formed at constant intervals, or it can be formed at irregular intervals.

In the embodiment of FIG. 20, at least one pair of the plurality of first openings OPr, OPg, OPb of the pixel defining layer 380 and the plurality of second openings OPCFr, OPCFg, OPCFb of the color filter has an elliptical shape.

As a result, as described above, it can have the advantage of less color separation of external light or a constant diffraction pattern or color separation regardless of angle.

Meanwhile, the embodiment of FIG. 20 is an embodiment in which the oval shape for one or two colors of the embodiment of FIG. 9 is changed to a circle shape, but in the embodiment of FIG. 7 or FIG. 8, the oval shape is changed to a circle shape for one or two colors, the oval shape can be changed to a circle shape.

In addition, in the embodiments of FIGS. 18 and 19, the oval shape can be changed to a circle shape for one or two colors.

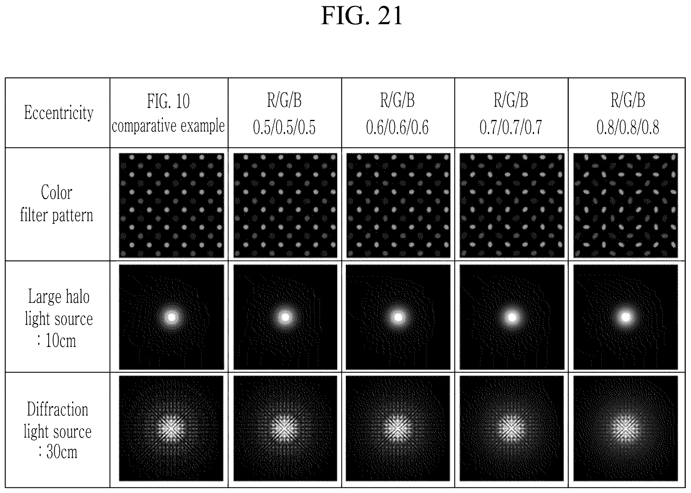

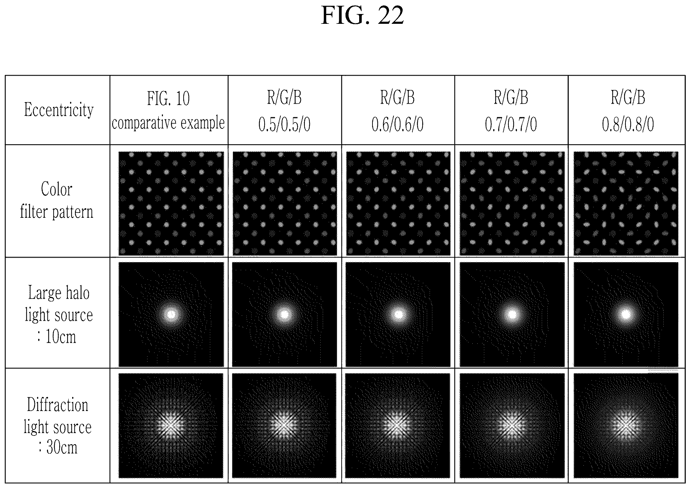

Hereinafter, reflection characteristics according to eccentricity for various embodiments will be explained through FIGS. 21 and 22.

FIGS. 21 and 22 are diagrams showing reflection characteristics according to eccentricity.

First, FIG. 21 shows reflection characteristics while changing the eccentricity in a display device having the same eccentricity as in FIG. 7.

The eccentricity values described in FIG. 21 are values of the plurality of second openings OPCFr, OPCFg, OPCFb of the color filter.

In FIG. 21, two photos are included. One is a photo taken with external light provided at 10cm, and the other is a photo taken with external light provided at 30cm.

Here, the photo taken at 10cm shows the size and intensity of the halo that occurs around strong light, and the photo taken at 30cm shows the characteristic of external light being reflected and diffracted.

Referring to FIG. 21, in the comparative example of FIG. 10, a ring-shaped halo is strongly visible as external light is reflected, but in the example using an ellipse, the eccentricity is 0.5, 0.6, 0.7, and 0.8, there is an advantage that the ring-shaped halo is not visible.

Meanwhile, FIG. 22 shows reflection characteristics in an embodiment in which one color has a circular shape rather than an oval shape and the other two colors have an oval shape, as in FIG. 20.

In FIG. 22, unlike FIG. 20, the blue has a circular shape-specifically, the blue first opening OPb of the pixel defining layer 380 and the blue second opening OPCFb of the color filter have a circular shape, while the remaining openings have an elliptical shape.

At this time, FIG. 22 shows the reflection characteristics while changing the eccentricity of the oval-shaped opening.

The eccentricity values described in FIG. 22 are values of the plurality of second openings OPCFr, OPCFg, OPCFb of the color filter, and 0 represents a circular shape.

Referring to FIG. 22, in the comparative example of FIG. 10, the halo, which is a ring-shaped pattern, is strongly visible as external light is reflected, but in the example including at least one oval, the halo is not visible.

Also, since no halo is recognized in the photos of FIG. 22 corresponding to the embodiment of FIG. 20 and in the photos of the embodiment of FIG. 7 shown in FIG. 21, it can be confirmed that the embodiment of FIG. 20 has an effect comparable to the embodiment of FIG. 7.

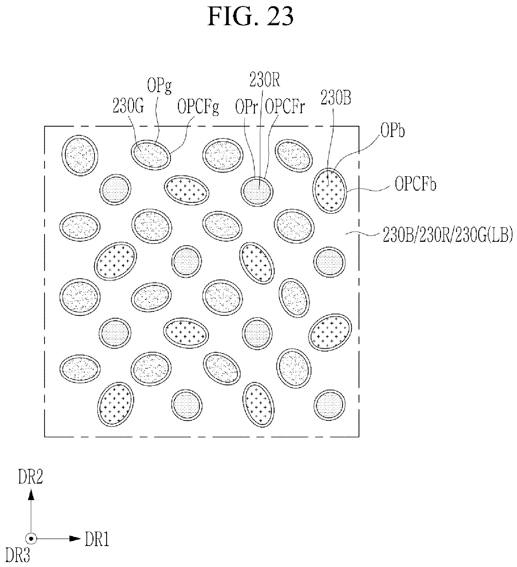

Meanwhile, hereinafter, another modified embodiment will be looked at through FIGS. 23 to 25.

FIG. 23 to FIG. 25 are plan views of a portion of a display panel according to another exemplary embodiment.

First, the embodiment of FIG. 23 will be explained.

Referring to FIGS. 20 and 22, it was confirmed that the embodiment in which one or two colors were formed in an oval shape and the remaining colors were formed in a circle shape had an effect similar to the embodiment in which all colors were formed in an oval shape.

Therefore, depending on the embodiment, an oval shape can be used instead of a circle shape, and it can be seen that a similar effect can be achieved even with an eccentricity (more than 0 and less than 0.2) than the eccentricity (0.2 to 0.85) defined above.

One of these embodiments will be explained through FIG. 23.

FIG. 23 is a modified example of FIG. 20, in which the two red first openings OPr, OPCFr in FIG. 20 are transformed into ellipses with an eccentricity of more than 0 and less than 0.2 instead of circular shapes.

Specifically, the embodiment of FIG. 23 is based on the embodiment of FIG. 9, and differs from FIGS. 9 and 20 in that the red first opening OPr of the pixel defining layer 380 and the red second opening OPCFr of the color filter have an oval shape having an eccentricity of greater than 0 and less than 0.2.

In other words, the green first opening OPg and blue first opening OPb of the pixel defining layer 380, and the green second opening OPCFg and blue second opening OPCFb of the color filter all have an elliptical shape with an eccentricity of 0.2 or more and 0.85 or less.

Meanwhile, depending on the embodiment, one additional color in addition to red among the three color openings may have an oval shape with an eccentricity of more than 0 and less than 0.2.

That is, depending on the embodiment, one or both of the red first opening OPr, green first opening OPg, and blue first opening OPb of the pixel defining layer 380 have an elliptical shape with an eccentricity of more than 0 and less than 0.2. and the remainder may have an elliptical shape with an eccentricity of 0.2 or more and 0.85 or less.

In addition, the red second opening OPCFr, the green second opening OPCFg, and the blue second opening OPCFb of the color filter are the corresponding red first openings OPr of the pixel defining layer 380, the green first opening OPg and the blue first opening OPb. Each may have a shape corresponding to the planar shape, and the red first opening OPr, the green first opening OPg, and the blue opening of the pixel defining layer 380 may have a certain horizontal distance from the first opening OPb.

At this time, the first openings OPr, OPg, OPb of the pixel defining layer 380 and the second openings OPCFr, OPCFg, OPCFb of the color filter corresponding thereto may have the same elliptical major axis direction.

In FIG. 23, as in the embodiment of FIG. 9, the second openings OPCFr, OPCFg, OPCFb of the color filter and the first openings OPr, OPg, OPb of the pixel defining layer 380 are different even for the same color, they are formed in an eccentric oval shape, and the second openings OPCFr, OPCFg, OPCFb of the color filter and the first openings OPr, OPg, OPb of the pixel defining layer 380 have angles formed by their major axes of four or more angles, and the angles formed by the major axes may be arranged at intervals of 45 degrees or less.

Depending on the embodiment, among the plurality of first openings OPr, OPg, OPb of the pixel defining layer 380 or the plurality of second openings OPCFr, OPCFg, OPCFb of the color filter, the elliptical major axis direction is formed at constant intervals, or it can be formed at irregular intervals.

In the embodiment of FIG. 23, at least one pair of the plurality of first openings OPr, OPg, OPb of the pixel defining layer 380 and the plurality of second openings OPCFr, OPCFg, OPCFb of the color filter has oval shape with an eccentricity of 0.2 or more and 0.85 or less.

As a result, as described above, it can have the advantage of less color separation of external light or a constant diffraction pattern or color separation regardless of angle.

Meanwhile, in the embodiment of FIG. 23, the oval shape for one or two colors of the embodiment of FIG. 9 is changed to an oval shape with an eccentricity of more than 0 and less than 0.2, but any of the embodiments of FIG. 7 or FIG. 8 can also change the oval shape can be changed to an oval shape with an eccentricity of more than 0 and less than 0.2.

In addition, in the embodiments of FIGS. 18 and 19, the elliptical shape for one or two colors can be changed to an elliptical shape with an eccentricity of more than 0 and less than 0.2.

Meanwhile, in the above embodiments, the first openings OPr, OPg, OPb of the pixel defining layer 380 and the second openings OPCFr, OPCFg, OPCFb of the color filter corresponding thereto were explained with a focus on an embodiment in which the second openings OPCFr, OPCFg, OPCFb of the pixel defining layer 380 are spaced apart at regular intervals on a plane.

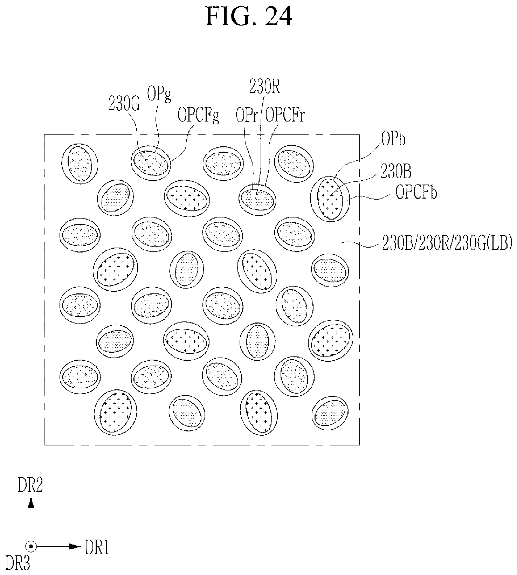

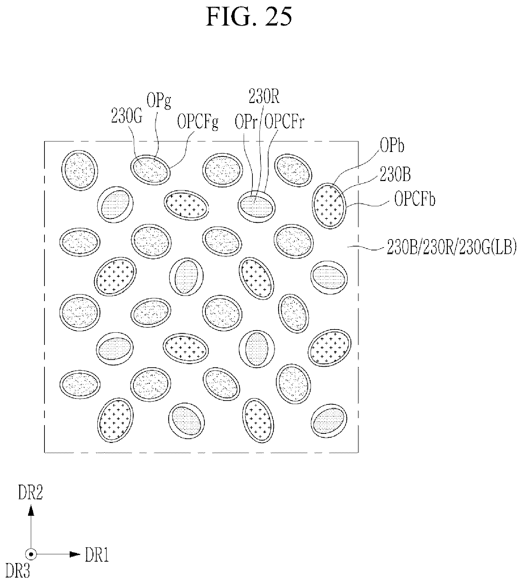

However, depending on the embodiment, the horizontal interval between the first openings OPr, OPg, OPb of the pixel defining layer 380 and the second openings OPCFr, OPCFg, OPCFb of the corresponding color filter may change depending on the position. This embodiment will be explained through FIGS. 24 and 25.

Here, the horizontal gap between the first openings OPr, OPg, OPb of the pixel defining layer 380 and the second openings OPCFr, OPCFg, OPCFb of the corresponding color filter may be greater than 0 µm and less than or equal to 20 µm.

First, the embodiment of FIG. 24 will be explained.

In FIG. 24, an embodiment is shown where the second openings OPCFr, OPCFg, OPCFb of the red, green, and blue color filters and the corresponding first openings OPr, OPg, OPb of the pixel defining layer 380 are formed as ellipses with different eccentricities.

In the embodiment of FIG. 24, the eccentricity of the second openings OPCFr, OPCFg, OPCFb of the color filter may have a smaller value than the eccentricity of the corresponding first openings OPr, OPg, OPb of the pixel defining layer 380.

However, depending on the embodiment, the eccentricity of the first openings OPr, OPg, OPb of the pixel defining layer 380 may have a smaller value than the eccentricity of the second openings OPCFr, OPCFg, OPCFb of the corresponding color filter.

Referring to FIG. 24, the horizontal spacing between the first openings OPr, OPg, OPb of the pixel defining layer 380 and the second openings OPCFr, OPCFg, OPCFb of the corresponding color filters is not constant, and there are wide and narrow locations.

In the embodiment of FIG. 24, the corresponding first openings OPr, OPg, OPb of the pixel defining layer 380 and the second openings OPCFr, OPCFg, OPCFb of the color filter may have the same oval-shaped major axis direction.

As shown in FIG. 24, even if the horizontal interval between the first openings OPr, OPg, OPb of the pixel defining layer 380 and the second openings OPCFr, OPCFg, OPCFb of the corresponding color filters are not constant, as described above, due to the direction or various eccentricities, there may be an advantage in that color separation of external light occurs less or a constant diffraction pattern or color separation occurs regardless of the angle.

Additionally, even if external light is reflected, the halo, a ring-shaped pattern, may not be visible.

In the embodiment of FIG. 24, as in the embodiment of FIG. 9, the second openings OPCFr, OPCFg, OPCFb of the color filter and the first openings OPr, OPg, OPb of the pixel defining layer 380 may be formed in the shape of ellipses of different eccentricities even for the same color. The second openings OPCFr, OPCFg, OPCFb of the color filter and the first openings OPr, OPg, OPb of the pixel defining layer 380 may be disposed such that their respective major axes have form four or more angles with respect to a basis direction, e.g. the first direction DR1, and the angles formed by their major axes may have an interval of 45 degrees or less.

Here, the eccentricity of the oval shape may range from 0.2 to 0.85.

Depending on the embodiment, among the plurality of first openings OPr, OPg, OPb of the pixel defining layer 380 or the plurality of second openings OPCFr, OPCFg, OPCFb of the color filter, the elliptical major axis direction can be formed at constant intervals or at irregular intervals.

Meanwhile, depending on the embodiment, the part where the horizontal spacing is not constant, as shown in FIG. 24, may be applied to only one or two colors.

This embodiment will be explained through FIG. 25.

The embodiment of FIG. 25 is based on the embodiment of FIG. 24, and only the red first opening OPr of the pixel defining layer 380 and the red second opening OPCFr of the color filter have a structure in which the horizontal spacing is not constant, the green first opening OPg and blue first opening OPb of the pixel defining layer 380 and the green second opening OPCFg and blue second opening OPCFb of the color filter have a structure where the horizontal spacing is constant.

Meanwhile, depending on the embodiment, among the three-color openings, one color in addition to red may have a shape with uneven horizontal spacing.

That is, depending on the embodiment, one or two of the red first opening OPr, the green first opening OPg, and the blue first opening OPb of the pixel defining layer 380 may have a shape that is not uniformly spaced horizontally with the second red openings, the red second opening OPCFr, the green second opening OPCFg, and the blue second opening OPCFb of the corresponding color filter.

In the embodiment of FIG. 25, at least one pair of the plurality of first openings OPr, OPg, OPb of the pixel defining layer 380 and the plurality of second openings OPCFr, OPCFg, OPCFb of the color filter has a shape with constant horizontal spacing.

As a result, as described above, it can have the advantage of less color separation of external light or a constant diffraction pattern or color separation, regardless of angle.

Additionally, even if external light is reflected, the halo, a ring-shaped pattern, may not be visible.

Meanwhile, the embodiments of FIGS. 24 and 25 are modified embodiments based on the embodiments of FIG. 9, but can be modified so that the horizontal spacing is not constant even based on the embodiments of FIGS. 7 and 8.

In addition, in the embodiments of FIGS. 18 and 19, the horizontal spacing can be changed to be non-constant.

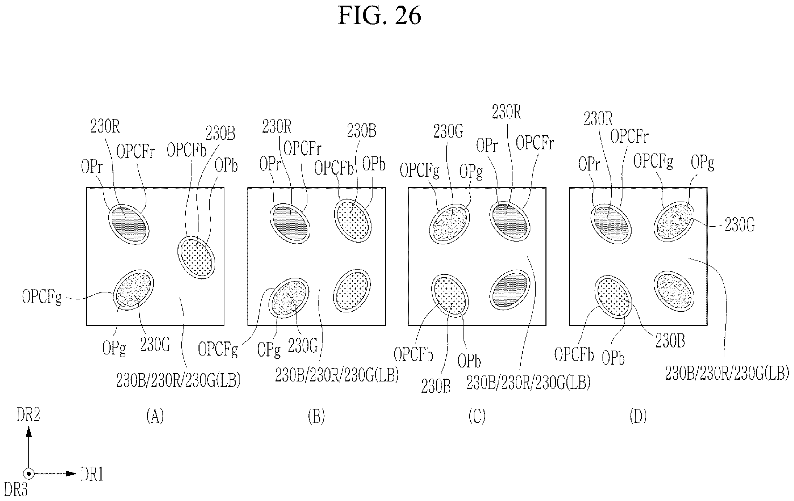

Below, we will look at the structure of one unit pixel through FIG. 26.

FIG. 26 is a plan view showing the configuration of a unit pixel of one of the display panels according to an embodiment.

(A) of FIG. 26 shows an example in which a unit pixel is formed by including one red, green, and blue light emitting region.

Specifically, an embodiment includes one each of a red first opening OPr, a green first opening OPg, and a blue first opening OPb of the pixel defining layer 380, and a red second opening OPCFr, a green second opening OPCFg, and a blue second opening OPCFb of the color filter in each pixel.

However, according to the embodiment, it can include a unit pixel that includes a total of four light emitting regions, including two of one color, as in (B), (C), and (D) of FIG. 26.

(B) of FIG. 26 shows a unit pixel containing two blue-light emitting areas, (C) of FIG. 26 shows a unit pixel containing two red-light emitting areas, and (D) of FIG. 26 shows a unit pixel containing two red-light emitting areas, a unit pixel containing two green-light emitting areas is shown.

Specifically, the unit pixel in (B) of FIG. 26 includes two blue first openings OPb of the pixel defining layer 380 and two blue second openings OPCFb of the color filter.

At this time, the two blue first openings OPb of the pixel defining layer 380 and the two blue second openings OPCFb of the color filter may have different eccentricities, and the directions of their major axes may also be different.

Additionally, the unit pixel in (C) of FIG. 26 includes two red first openings OPr of the pixel defining layer 380 and two red second openings OPCFr of the color filter.

At this time, the two red first openings OPr of the pixel defining layer 380 and the two red second openings OPCFr of the color filter may have different eccentricities, and the directions of their major axes may also be different.

Meanwhile, the unit pixel in (D) of FIG. 26 includes two green first openings OPg of the pixel defining layer 380 and two green second openings OPCFg of the color filter.

At this time, the two green first openings OPg of the pixel defining layer 380 and the two green second openings OPCFg of the color filter may have different eccentricities, and the directions of their major axes may also be different.

A plurality of first openings OPr, OPg, OPb of the pixel defining layer 380 and a plurality of second openings OPCFr, OPCFg, OPCFb of the color filter of various embodiments described above or modifications thereof may be applied to each unit pixel of FIG. 26.

In the above, an embodiment in which the first opening OP of the pixel defining layer 380 and the second opening OPCF of the color filter have an ellipse or ellipse-like shape was explained.

Hereinafter, an embodiment in which one of the first opening OP of the pixel defining layer 380 and the second opening OPCF of the color filter has an ellipse or an ellipse-like shape, and the other has a circular shape will be explained.

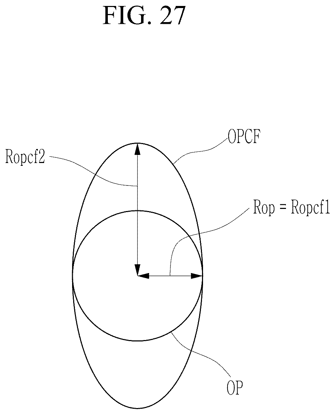

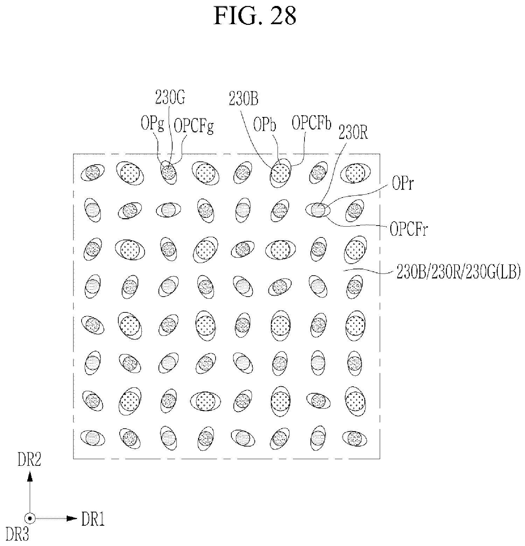

Through FIGS. 27 and 28, the second opening OPCF of the color filter may have an elliptical shape, the first opening OP of the pixel defining layer 380 may have a circular shape, and an embodiment where the second opening OPCF of the color filter and the first opening OP of the pixel defining layer 380 meet will be explained.

FIG. 27 and FIG. 28 are plan views of a portion of a display panel according to another embodiment.

In FIG. 27, only the first opening OP of one pixel defining layer and the second opening OPCF of one color filter corresponding thereto are shown.

In FIG. 27, the pixel defining layer is located outside the first opening OP, and the light blocking area LB of the color filter is also located outside the second opening OPCF.

In the embodiment of FIG. 27, the first opening OP of the pixel defining layer 380 has a circular planar shape, and the second opening OPCF of the color filter has an elliptical planar shape.

The second opening OPCF of the oval-shaped color filter has a structure that contacts the circular first opening OP of the pixel defining layer 380 at two points.

In the embodiment of FIG. 27, the radius value Rop of the circular shape of the first opening OP of the pixel defining layer 380 is half the minor axis length Ropcf1 of the elliptical shape of the second opening OPCF of the color filter, and is less than half the major axis length Ropcf2 of the elliptical shape.

The half value Ropcf2 of the major axis length of the elliptical shape may be larger than the radius value Rop of the circular shape of the first opening OP of the pixel defining layer 380 by more than 0 µm and less than or equal to 20 µm, and depending on the embodiment, it can be as large as 4.5 µm or more and 10 µm or less.

The length of the major axis of the oval shape may vary in horizontal distance depending on the thickness of the layer (e.g., encapsulation layer) located between the light blocking area LB of the color filter and the pixel defining layer 380 in cross-section, and the encapsulation layer is about 6 µm.

Here, the ellipse has two foci, can have a shape connecting points where the sum of the distances to the two foci is constant, and can have a major axis and a minor axis.

Meanwhile, the eccentricity of an ellipse is the distance between two foci divided by the length of the major axis.

When the eccentricity is 0, it is a circle, and when it is 1, it forms a parabola, so an ellipse has an eccentricity value that is greater than 0 and less than 1.

The eccentricity value of the ellipse, which is the shape of the second opening OPCF of the color filter, may vary depending on the embodiment.

Meanwhile, the direction of the major axis of the second opening OPCF of the color filter may also vary.

Meanwhile, in the embodiment of FIG. 27, the first opening OP of the pixel defining layer 380 and the second opening OPCF of the color filter contact at two points on the plane, but due to errors during actual processing, a portion of one side of the first opening OP of the pixel defining layer 380 may be covered with the light blocking area LB of the color filter without overlapping the second opening OPCF of the color filter.

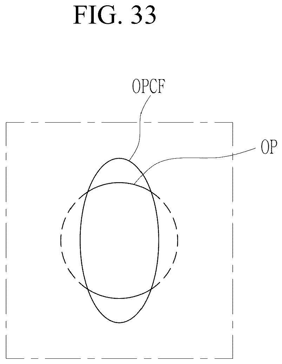

In this case, it can have a similar effect to the embodiment of FIG. 33 described later.

The first opening OP of the pixel defining layer 380 and the second opening OPCF of the color filter having the same structure as in FIG. 27 may be arranged as shown in FIG. 28 in the display area.

In FIG. 28, based on the light-emitting layer displaying the three primary colors of red, green, and blue, the first opening OP of the pixel defining layer 380 and the second opening OPCF of the color filter are respectively illustrated as first openings OPr, OPg, OPb, and second openings OPCFr, OPCFg, OPCFb.

Here, r, g, and b may correspond to red, green, and blue, respectively.

The second openings OPCFr, OPCFg, OPCFb of the color filter may be arranged at various angles, and the red second opening OPCFr, the green second opening OPCFg, and the blue second opening OPCFb of the color filter can have different eccentricities.

Meanwhile, each of the second openings OPCFr, OPCFg, OPCFb of the same color may be formed with the same or a different eccentricity.

Here, the eccentricity of the oval shape may range from 0.2 to 0.85.

At this time, the red first opening OPr, the green first opening OPg, and the blue first opening OPb of the pixel defining layer 380 may be formed as circles with different radii, and the same color first opening OPr, OPg, OPb can each have the same or a different radius.

The first openings OPr, OPg, OPb of one pixel defining layer 380 correspond to the second openings OPCFr, OPCFg, OPCFb of one color filter.

That is, within each of the second openings OPCFr, OPCFg, OPCFb of the color filter, the first openings OPr, OPg, OPb of the pixel defining layer 380 correspond to each of the second openings OPCFr, OPCFg, OPCFb of the color filter.

The second openings OPCFr, OPCFg, OPCFb of the corresponding color filters and the first openings OPr, OPg, OPb of the pixel defining layer 380 may overlap each other on a plane.

In the embodiment of FIG. 27, the circular first openings OPr, OPg, OPb of the pixel defining layer 380 and the oval-shaped second openings OPCFr, OPCFg, OPCFb of the color filter have structures in which they contact each other at two points on a plane.

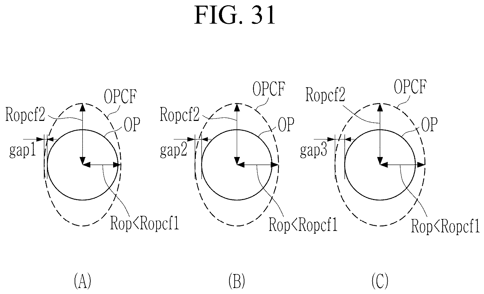

However, in another embodiment, the second openings OPCFr, OPCFg, OPCFb of the color filter may be larger, so that the circular first openings OPr, OPg, OPb of the pixel defining layer 380 may be formed within the second openings OPCFr, OPCFg, OPCFb of the color filter on the plane of the planar color filter (see FIG. 31). It is also possible to have a structure (see FIG. 33) in which the second openings OPCFr, OPCFg, OPCFb of the color filter are relatively small and cover some of the circular first openings OPr, OPg, OPb of the pixel defining layer with the light blocking area LB of the planar color filter in still another embodiment.

In FIG. 28, the second openings OPCFr, OPCFg, OPCFb of the color filter are arranged in various directions, and the angles at which the second openings OPCFr, OPCFg, OPCFb are arranged will be explained based on the major axis direction of the ellipse.

Depending on the embodiment, the angle formed by each major axis of the second opening OPCFr, OPCFg, OPCFb of the color filter may have four or more angles, and the angle formed by the major axis may be at intervals of 45 degrees or less.

As an example, looking at specific angle relationships focusing on an embodiment with five angles, the relationship is as follows.

In the embodiment with 5 angles, the angles of the major axes are formed at intervals of 36 degrees, so when one major axis has 0 degrees based on the first direction DR1, the angles of 36 degrees, 72 degrees, 108 degrees, and 144 degrees are formed, for a total of 5 angles.

In other words, the distance between the angles of the major axis can be checked by dividing the angle of 180 degrees by 5, which is the number of directions, which means that the two angles with an angle of 180 degrees out of 360 degrees have substantially the same direction of the major axis of the ellipse. This may be calculated by dividing by the number of directions based on 180 degrees.

The plurality of second openings OPCFr, OPCFg, OPCFb of the color filter may be arranged at constant intervals at a specific angle of 45 degrees or less.

However, depending on the embodiment, the angle formed by the major axis of each of the second openings OPCFr, OPCFg, OPCFb may be one of 45 degrees or less and may be arranged at irregular intervals.

The embodiment in which the major axes of the openings are arranged at irregular intervals may be intentionally arranged to reduce the diffraction pattern, or may be arranged at irregular intervals due to processing errors.

Meanwhile, in order to make a pixel unit that includes openings of red, green, and blue have a square structure, it may be necessary to form them by distinguishing the number corresponding to the square of integers, such as 2², 3², 4², 5², etc., for the angle of the major axis.

Here, the unit pixel may include one each of red, green, and blue openings, and a plurality of openings of one color-for example, green openings-may be formed.

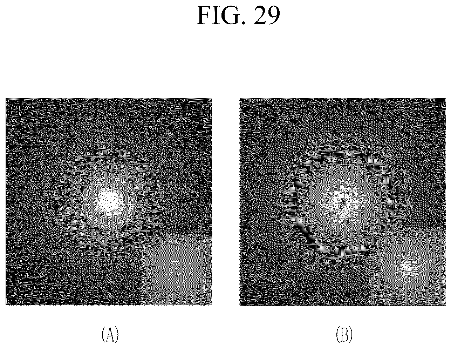

In this way, the first openings OPr, OPg, OPb of the pixel defining layer 380 are formed in a circular shape, and the reflection characteristics when the second openings OPCFr, OPCFg, OPCFb of the color filter are formed in an elliptical shape are shown in FIG. 29.

FIG. 29 is a photograph of the reflection characteristics of the comparative example and the example of FIG. 28.

(A) of FIG. 29 shows the diffraction pattern and color dispersion of reflected light for the comparative example, and (B) of FIG. 29 shows the diffraction pattern and color dispersion of reflected light for the example of FIG. 28.

Here, in the comparative example, as shown in FIG. 10, both the first openings OPr, OPg, OPb of the pixel defining layer 380 and the second openings OPCFr, OPCFg, OPCFb of the color filter are formed in a circular shape.

First, looking at the comparative example of (A) of FIG. 29, the diffraction pattern is formed in a plurality of ring shapes, each ring shape can be clearly seen, and each ring represents a different color, so the user can see that the reflected light is separated into colors.

In contrast, referring to (B) of FIG. 29, it can be seen that the diffraction pattern is relatively unclear and the shape of the ring is not clear.

This lack of clarity in the diffraction pattern may occur for the following reasons.

First, the first openings OPr, OPg, OPb of the pixel defining layer 380 are formed in a circular shape, and if the second openings OPCFr, OPCFg, OPCFb of the color filter are formed in an elliptical shape, the gap between the two openings is not constant, the light emitted from the light emitting layer located within the first openings OPr, OPg, OPb of the pixel defining layer 380 is bent at the side wall of the second openings OPCFr, OPCFg, OPCFb of the color filter, and the resulting diffraction patterns are different.

Therefore, when diffraction patterns are mixed, less constructive interference occurs and the diffraction patterns are blurred.

Therefore, according to the second openings OPCFr, OPCFg, OPCFb of the elliptical color filter, the diffraction pattern spreads and does not become clear.

In addition, referring to FIG. 28, since the second openings OPCFr, OPCFg, OPCFb of the elliptical color filter are arranged at various angles, this also causes the direction of the diffraction pattern to vary, forming a blurred mix and resulting in a scattering effect.

Due to this mixing of diffraction patterns, the diffraction pattern is not clear and the user cannot easily see the diffraction pattern, thereby reducing the degree to which display quality is degraded.

Depending on the embodiment, the major axes of the second openings OPCFr, OPCFg, OPCFb of the elliptical color filter may be arranged at four or more angles or may be arranged at intervals of 45 degrees or less, in which case the lower diffraction patterns and color separation may occur.

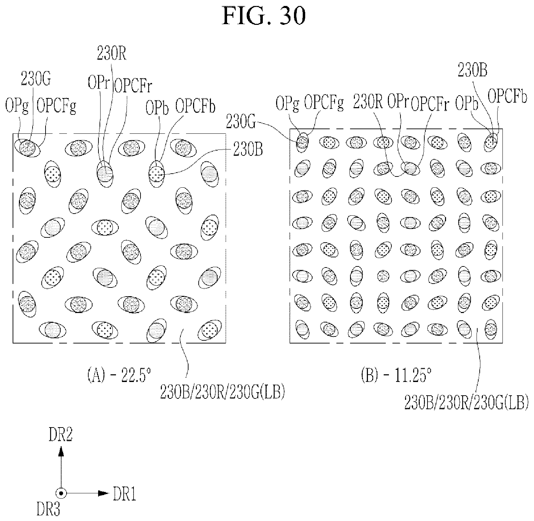

Meanwhile, in the following, two embodiments having a specific angular gap formed by the major axes of the second openings OPCFr, OPCFg, OPCFb of the elliptical color filter in the embodiment shown in FIG. 27 will be looked at through FIG. 30.

FIG. 30 is a plan view of a portion of the display panel in the embodiment of FIG. 27 arranged at various angles.

First, (A) of FIG. 30 shows an embodiment in which the major axes of the second openings OPCFr, OPCFg, OPCFb of the elliptical color filter are arranged at an angular interval of 22.5 degrees.

Meanwhile, (B) of FIG. 30 shows an example in which the major axes of the second openings OPCFr, OPCFg, OPCFb of the color filter are arranged at an angular interval of half that of (A) of FIG. 30-that is, 11.25 degrees.

Here, in the embodiment of (A) of FIG. 30 with an angular spacing of 22.5 degrees, there can be 8 angles formed by the major axes of the second openings OPCFr, OPCFg, OPCFb of the color filter having an elliptical shape.

That is, since 180 degrees divided by 8 is 22.5 degrees, the major axes of the second openings OPCFr, OPCFg, OPCFb of the color filter can be arranged in 8 directions.

Here, it is calculated based on 180 degrees rather than 360 degrees because the two angles with a difference of 180 degrees are substantially the same direction.

Meanwhile, an embodiment of (B) of FIG. 30 having an angle interval of 11.25 degrees has twice as many angles as the embodiment of (A) of FIG. 30, and the major axes of the second openings OPCFr, OPCFg, OPCFb of the color filter are arranged in a total of 16 directions.

In the two embodiments arranged as shown in FIG. 30, the major axis arrangement angle of the second openings OPCFr, OPCFg, OPCFb of the color filter is more than 4, so the diffraction pattern is mixed without a specific directionality, allowing the user to determine the directionality of the diffraction pattern. However, the display quality may be improved because color separation is not easily recognized.

In FIG. 30, the major axes of the plurality of second openings OPCFr, OPCFg, OPCFb of the color filter are arranged at constant intervals, but depending on the embodiment, they may be arranged at irregular intervals at an angle of 45 degrees or less.

In the above, as shown in FIG. 27, the first opening OP of the pixel defining layer 380 may have a circular shape, the second opening OPCF of the color filter may have an elliptical shape, and a circle and an ellipse are tangential to each other on a plane.

However, either the first opening OP of the pixel defining layer 380 or the second opening OPCF of the color filter may be relatively large, and this embodiment will be explained through FIGS. 31 to 37.

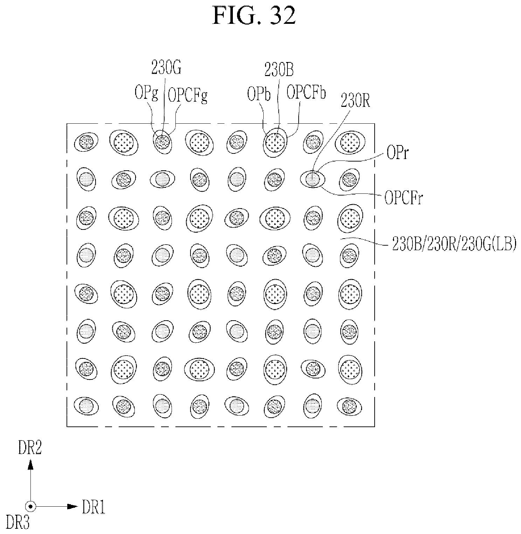

First, through FIGS. 31 and 32, the first opening OP of the pixel defining layer 380 is located within the second opening OPCF of the color filter, so that the first opening OP of the pixel defining layer 380 blocks light of the color filter. An example that is not obscured by a region will be explained next.

FIG. 31 and FIG. 32 are plan views of a portion of a display panel according to another embodiment.

First, FIG. 31 shows that the second opening OPCF of the color filter can be formed at various intervals gap1, gap2, gap3 depending on how much larger the first opening OP of the pixel defining layer 380 is formed.

In FIG. 31, the second opening OPCF of the color filter is large, so the circular first opening OP of the pixel defining layer 380 is located within the second opening OPCF of the color filter in a plan view.

Therefore, in the embodiment of FIG. 31, the radius value Rop of the circular shape of the pixel defining layer 380's first opening OP is smaller than half the value of the minor axis length Ropcf1 of the elliptical shape of the second opening OPCF of the color filter, and also smaller than half the value of the major axis length Ropcf2 of the elliptical shape.

The half value Ropcf2 of the major axis length of the elliptical shape may be larger than the radius value Rop of the circular shape of the first opening OP of the pixel defining layer 380 by more than 0 µm and less than or equal to 20 µm.

Specifically, in (A) of FIG. 31, the minimum horizontal gap in the plan view between the second opening OPCF of the color filter and the first opening OP of the pixel defining layer 380 is gap1, which is a relatively small value, but in (B) of FIG. 31, the minimum horizontal gap is relatively large at gap2 compared to the gap1, and in (C) of FIG. 31, the minimum horizontal gap is gap3, which is the largest among the gap1 to gap3.

In (A) to (C) of FIG. 31, the elliptical eccentricity of the second opening OPCF of the color filter may also be different.

Here, the eccentricity of the oval shape may range from 0.2 to 0.85.

Meanwhile, in the embodiment of FIG. 31, due to errors during the actual process, a portion of the first opening OP of the pixel defining layer 380 first opening OP may not overlap the color filter's second opening OPCF and may be covered by the color filter of the light blocking area LB.

Additionally, the first opening OP of the pixel defining layer 380 is located within the second opening OPCF of the color filter, but may be located closer to one boundary or may be in planar contact with one boundary.

Meanwhile, FIG. 32 shows an embodiment in which the elliptical major axes of the second openings OPCFr, OPCFg, OPCFb of the color filter are arranged at various angles.

Additionally, the second openings OPCFr, OPCFg, OPCFb of the color filter in FIG. 32 have different eccentricities for each color.

Depending on the embodiment, the two openings corresponding to the same color among the second openings OPCFr, OPCFg, OPCFb of the color filters may have different eccentricities, and depending on the embodiment, the second openings OPCFr, OPCFg, OPCFb may have the same eccentricity.

Additionally, the major axes of the second openings OPCFr, OPCFg, OPCFb of the elliptical color filter may be arranged at 4 or more angles and may be arranged at intervals of 45 degrees or less.

The embodiment of FIG. 31 may also be arranged with 8 major axis directions at angular intervals of 22.5 degrees, as shown in (A) of FIG. 30, or may be arranged with 16 major axis directions at angular intervals of 11.25 degrees, as shown in (B) of FIG. 30.

In FIG. 32, the major axis directions of the plurality of second openings OPCFr, OPCFg, OPCFb of the color filter are arranged at constant intervals, but in the embodiment of FIG. 31, they may be arranged at irregular intervals at an angle of 45 degrees or less depending on the embodiment.

In the above, an embodiment in which the first opening OP of the pixel defining layer 380 is located within the second opening OPCF of the color filter has been explained.

Hereinafter, a structure in which the second opening OPCF of the color filter is relatively small and a portion of the circular first opening OP of the pixel defining layer 380 is covered by the light blocking area LB of the color filter on a plane will be explained through FIGS. 33 to 37.

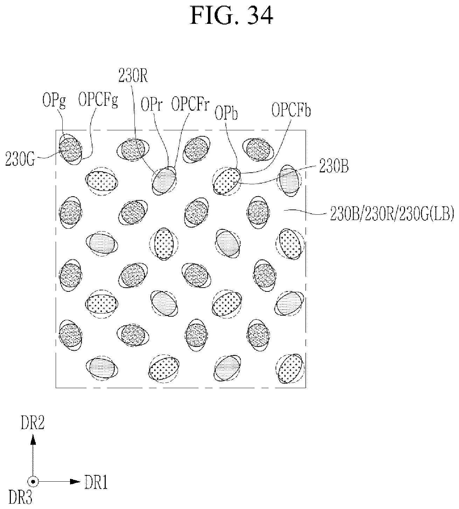

First, the relationship between the second opening OPCF of the basic color filter and the first opening OP of the pixel defining layer 380 will be explained through FIGS. 33 and 34.

FIG. 33 and FIG. 34 are plan views of a portion of a display panel according to another embodiment.

In FIG. 33, only the first opening OP of one pixel defining layer 380 and the second opening OPCF of one color filter corresponding thereto are shown.

The second opening OPCF of the color filter overlaps a portion of the first opening OP of the pixel defining layer 380, and the remaining portion of the first opening OP of the pixel defining layer 380 is covered with the light blocking area LB of the color filter.

As a result, the light emitting layer located within the first opening OP of the pixel defining layer 380 may be partially obscured by the light blocking area LB of the color filter.

In FIG. 33, part of the first opening OP of the pixel defining layer 380 is shown with a dotted line to indirectly show that the corresponding part is located below the light blocking area LB of the color filter and is obscured.

Meanwhile, in the embodiment of FIG. 33, due to errors during actual processing, the portion of the first opening OP of the pixel defining layer 380 that is obscured by the light blocking area LB of the color filter may not be constant on both sides and the area on one side may be larger.

Additionally, one side of the first opening OP of the pixel defining layer 380 may be located within or in contact with the second opening OPCF of the color filter, and only the other side may be obscured by the light blocking area LB of the color filter.

As shown in FIG. 33, if a part of the first opening OP of the pixel defining layer 380 is covered by the shading area of the color filter, the light emitted from the light emitting layer inside the first opening OP may not be provided to the front, which may reduce light efficiency.

However, the size of the first opening OP of the pixel defining layer 380 is related to the lifespan of the light emitting layer located therein, so the size of the first opening OP may not be reduced in order to maintain the lifespan above a certain level.

The first opening OP of the pixel defining layer 380 and the second opening OPCF of the color filter having the same structure as shown in FIG. 33 may be arranged as shown in FIG. 34.

Referring to FIG. 34, the elliptical major axes of the second openings OPCFr, OPCFg, OPCFb of the color filter are arranged at various angles.

Here, the first openings OPr, OPg, OPb of the pixel defining layer 380 are each formed in a circular shape, and a portion of the first openings OPr, OPg, OPb is the second opening OPCFr, OPCFg, OPCFb of the color filter. However, the remaining portion does not overlap the second openings OPCFr, OPCFg, OPCFb of the color filter and is therefore hidden by the light blocking area LB of the color filter.

Additionally, the second openings OPCFr, OPCFg, OPCFb of the color filter in FIG. 34 have different eccentricities for each color.

Depending on the embodiment, two openings corresponding to the same color among the second openings OPCFr, OPCFg, OPCFb of the color filters may have different eccentricities, and depending on the embodiment, the second openings OPCFr, OPCFg, OPCFb may have the same eccentricity.

Here, the eccentricity of the oval shape may range from 0.2 to 0.85.

Additionally, the major axes of the second openings OPCFr, OPCFg, OPCFb of the elliptical color filter may be arranged at 4 or more angles and may be arranged at intervals of 45 degrees or less.

The embodiment of FIG. 33 may also be arranged with 8 major axis directions at angular intervals of 22.5 degrees, as shown in (A) of FIG. 30, or may be arranged with 16 major axis directions at angular intervals of 11.25 degrees, as shown in (B) of FIG. 30.

In FIG. 34, the major axis directions of the plurality of second openings OPCFr, OPCFg, OPCFb of the color filter are arranged at constant intervals, but in the embodiment of FIG. 33, they may be arranged at irregular intervals at an angle of 45 degrees or less depending on the embodiment.

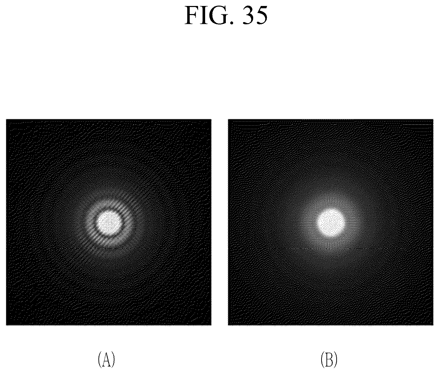

As described above, the diffraction characteristics of external light reflected in the embodiment in which part of the first openings OPr, OPg, OPb of the pixel defining layer 380 are obscured by the light blocking area LB of the color filter are explained in FIG. 35.

FIG. 35 is a photograph of the reflection characteristics of the comparative example and the embodiment of FIG. 34.

(A) of FIG. 35 is a diffraction pattern of a comparative example, and as shown in FIG. 10 described above, the first openings OPr, OPg, OPb of the pixel defining layer 380 and the second openings OPCFr, OPCFg, OPCFb of the color filter are all circular.

Meanwhile, (B) of FIG. 35 shows the diffraction pattern and color dispersion of reflected light for the embodiment of FIG. 34.

Comparing (B) of FIG. 35 with (A) of FIG. 35, it can be seen that the diffraction pattern in (B) of FIG. 35 is relatively unclear and the shape of the ring is not clearly visible.

In FIGS. 33 and 34, some of the first openings OPr, OPg, OPb of the pixel defining layer 380 are obscured by the light blocking area LB of the color filter, but as shown in FIG. 27, the first openings OPr, OPg, OPb are in contact with the second openings OPCFr, OPCFg, OPCFb of the color filter, or the first openings OPr, OPg, OPb of the pixel defining layer 380 are within the second openings OPCFr, OPCFg, OPCFb of the color filter as shown in FIG. 31. It can be seen that there is no significant difference in the diffraction pattern.

That is, even in the embodiment of FIG. 34, the gap between the two openings is not constant, so the resulting diffraction patterns may be different, and as each diffraction pattern is mixed, the overall diffraction pattern is formed blurry.

In addition, since the second openings OPCFr, OPCFg, OPCFb of the elliptical color filter are arranged at various angles, the directions of the diffraction patterns vary and are mixed together, forming a blur and a scattering effect.

As a result, users cannot easily recognize the diffraction pattern, and the degree to which display quality deteriorates is reduced.

In the above, the first openings OPr, OPg, OPb of the pixel defining layer 380 and the second openings OPCFr, OPCFg, OPCFb of the color filter are in contact with each other on a plane, or the second openings OPCFr, OPCFg, OPCFb of the color filter are planarly contiguous or whether all or part of the first openings OPr, OPg, OPb of the pixel defining layer 380 are located within the second openings OPCFr, OPCFg, OPCFb of the color filter.

Each of these embodiments can improve the reflection diffraction characteristics of external light by varying the arrangement of the major axis direction of the second openings OPCFr, OPCFg, OPCFb of the color filter or by varying the eccentricity of the ellipse.

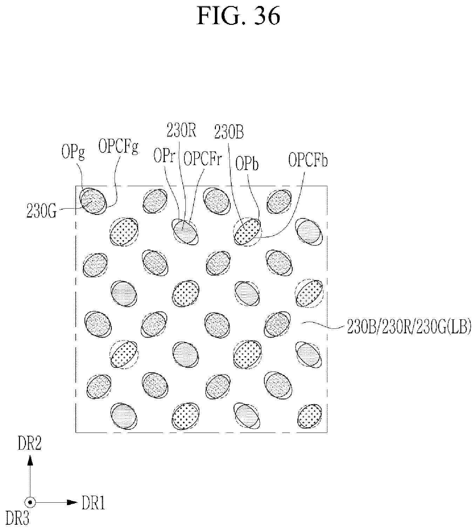

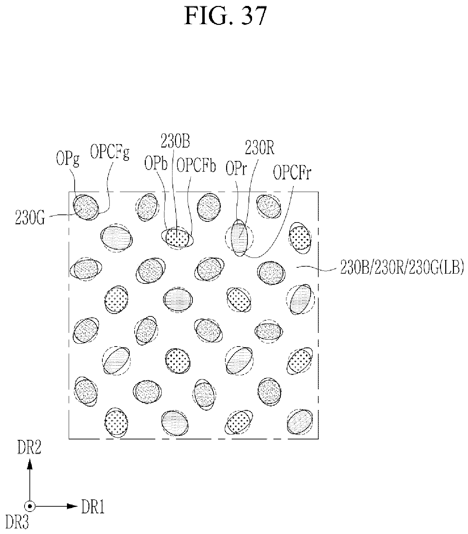

Hereinafter, an embodiment in which the eccentricity of the ellipse is varied or the arrangement of the major axis is varied will be explained through FIGS. 36 and 37.

FIG. 36 and FIG. 37 are plan views of a portion of a display panel according to another embodiment.

FIG. 36 shows an embodiment in which the second opening OPCF of the color filter is formed at various eccentricities, and FIG. 37 shows an embodiment in which the second opening OPCF of the color filter has various angles and is formed at various eccentricities.

Depending on the embodiment, the second opening OPCF of the color filter is formed with the same eccentricity, but may be formed at various angles.

Looking at the embodiment of FIG. 36, it is as follows.

FIG. 36 shows an embodiment in which the second openings OPCFr, OPCFg, OPCFb of the color filter are formed in an elliptical shape with two or more different eccentricities.

Depending on the embodiment, each opening of the same color may be formed into an oval shape with different eccentricities.

Here, the eccentricity of the oval shape may range from 0.2 to 0.85.

In FIG. 36, the major axis direction of the ellipse has only two directions forming 45 degrees with respect to the first direction DR1 or the second direction DR2.

Depending on the embodiment, it may have 4 or fewer directions.

Through FIG. 36, the planar structure of the second openings OPCFr, OPCFg, OPCFb of the color filter will be explained in detail.

In FIG. 36, the first openings OPr, OPg, OPb of the pixel defining layer 380 have a circular shape, and the second openings OPCFr, OPCFg, OPCFb of the color filter have an elliptical planar shape.

Some of the first openings OPr, OPg, OPb of the pixel defining layer 380 do not overlap in plan with the second openings OPCFr, OPCFg, OPCFb of the corresponding color filter and are therefore obscured by the light blocking area LB of the color filter.

The second openings OPCFr, OPCFg, OPCFb of the color filter have an oval-shaped major axis arranged in only two directions forming 45 degrees with respect to the first direction DR1 or the second direction DR2.

Meanwhile, the red second opening OPCFr, the green second opening OPCFg, and the blue second opening OPCFb of the color filter may each be formed as an ellipse with at least two different eccentricities.

Furthermore, in the embodiment of FIG. 36, the second openings OPCFr, OPCFg, OPCFb of the color filters of the same color may have at least two different eccentricities and thus have different elliptical planar shapes.

In FIG. 36, in the case of an opening of the same color but having different elliptical shapes with different eccentricities, the elliptical shapes with different eccentricities may be arranged in various positions at various ratios.

Depending on the embodiment, the same number of oval shapes with different eccentricities may be included in the display area, and they may be included in different numbers.

Referring to FIG. 36, the angle formed by each major axis of the plurality of second openings OPCFr, OPCFg, OPCFb of the color filters is 45 degrees with respect to the first direction DR1 and the second direction DR2.

In an embodiment in which the eccentricity of the ellipse is formed in various ways, the number of angles formed by the major axis of the ellipse may be 4 or less.

That is, in the embodiment of FIG. 36, various elliptical shapes with different eccentricities are formed to reduce color separation of external light or to generate a constant diffraction pattern or color separation regardless of angle.

Therefore, the embodiment of FIG. 36 can enable constant color separation and/or constant diffraction even without varying the direction of the major axis of the ellipse.

Meanwhile, the following is an examination of the embodiment of FIG. 37.

In FIG. 37, the second openings OPCFr, OPCFg, OPCFb of the color filters are formed in oval shapes with different eccentricities even for the same color, and the major axes of the second openings OPCFr, OPCFg, OPCFb of the color filters are formed at different angles. Four or more angles are formed by the major axes and the major axes are spaced at intervals of less than 45 degrees.

Here, the eccentricity of the oval shape may range from 0.2 to 0.85.

In the embodiment of FIG. 37, the eccentricity of the ellipse is varied and the major axis direction of the ellipse is also arranged in various ways.

Therefore, the plurality of first openings OPr, OPg, OPb of the pixel defining layer 380 or the plurality of second openings OPCFr, OPCFg, OPCFb of the color filters have four or more or are spaced at an angle of 45 degrees or less, while further varying the eccentricity of the ellipse so that color separation of external light occurs less or a constant, unclear diffraction pattern occurs regardless of the angle.

Depending on the embodiment, the major axis direction of the plurality of second openings OPCFr, OPCFg, OPCFb of the color filters may be formed at constant or irregular intervals.

Although FIGS. 36 and 37 show modified embodiments based on the embodiment of FIG. 33, the embodiment of FIG. 27 or FIG. 31 can be similarly modified.

A rough comparison of the embodiments of FIGS. 36 and 37, including additional embodiments in which only the major axis direction of the ellipse is formed in various ways while keeping the eccentricity constant, may be as shown in Table 2 below.

**[Table 2]**

| | The present exemplary embodiment | FIG. 36 exemplary embodiment | FIG. 37 exemplary embodiment |
|---|---|---|---|
| pixel defining layer opening eccentricity of the second opening ellipse of the color filter | circular shape red, green, blue same eccentricity | circular shape eccentricity equal to or more than 2different eccentricity by coloropening of the same color has a different eccentricity (A circle with an eccentricity of 0 is also possible.) | circular shape eccentricity equal to or more than 2different eccentricity by color opening of the same color has a different eccentricity (A circle with an eccentricity of 0 is also possible.) |
| color filter second opening area (aperture ratio) | same | area varies depending on eccentricity | area varies depending on eccentricity |
| arrange ratio | equalization arrange | total number of ellipses with different eccentricities is the same or different | total number of ellipses with different eccentricities is the same or different |
| color filter second opening ellipse major axis angle | 4 or more angles | 45 degrees, 2 total (4 or fewer angles are also possible.) | can be positioned at equal to or more than 4 angles |

Meanwhile, in the embodiments of FIGS. 27, 31, and 33, the second opening OPCF of one color filter has one eccentricity.

However, depending on the embodiment, as shown in FIG. 17, the second opening OPCF of one color filter may be formed by merging at least two elliptical shapes with different eccentricities.

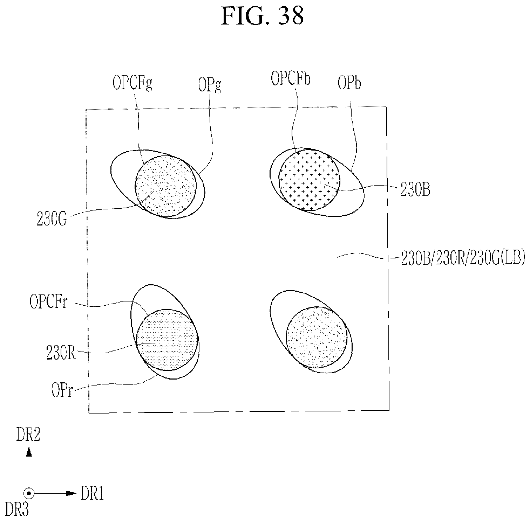

Hereinafter, with reference to FIG. 38, the first opening OP of the pixel defining layer 380 may have a circular shape, and the second opening OPCF of the color filter is an ellipse formed by merging at least two elliptical shapes with different eccentricities. An example of one of the embodiments having an elliptical shape will now be explained.

FIG. 38 is a diagram showing a structure merging ellipses with different eccentricities.

FIG. 38 shows an example of arranging the second openings OPCFr, OPCFg, OPCFb of the color filters and the first openings OPr, OPg, OPb of the pixel defining layer 380 in various major axis directions using elliptical shapes merged in the same manner as in (C) of FIG. 17.

In the embodiment of FIG. 38, the second openings OPCFr, OPCFg, OPCFb of the color filters and the first openings OPr, OPg, OPb of the pixel defining layer 380 may contact each other as shown in FIG. 27.

However, depending on the embodiment, the second openings OPCFr, OPCFg, OPCFb of the color filters may be formed larger than the first openings OPr, OPg, OPb of the pixel defining layer 380, as shown in FIG. 31, or as shown in FIG. 33, the second openings OPCFr, OPCFg, OPCFb of the color filters may have a structure that covers a portion of the first openings OPr, OPg, OPb of the pixel defining layer 380.

In the embodiment of FIG. 38, only one unit pixel is shown, and one unit pixel includes one red opening OPr, OPCFr, one blue opening OPb, OPCFb, and two green openings OPg, OPCFg.

In the embodiment of FIG. 38, the first openings OPr, OPg, OPb of the pixel defining layer 380 are formed in a circular shape, and the second openings OPCFr, OPCFg, OPCFb of the color filters are formed in a merged oval shape, and each of the direction of the major axis may also be different.

As shown in FIG. 38, the embodiment that uses an ellipse that is a combination of two ellipses with different eccentricities also uses the angles of the first openings OPr, OPg, OPb of the pixel defining layer 380 and the second openings OPCFr, OPCFg, OPCFb of the color filters, the angle formed by the major axis may have 4 or more angles, and the angles formed by the major axis may be arranged at intervals of 45 degrees or less.

Additionally, the eccentricities of the two ellipses used for merging may vary, so the size of the merged ellipses may also vary.

Additionally, depending on the embodiment, two ovals with different eccentricities for each color can be merged, and even if they are the same color, two ovals with different eccentricities can be merged to form various ovals.

Meanwhile, the first openings OPr, OPg, OPb of the pixel defining layer 380 and the corresponding second openings OPCFr, OPCFg, OPCFb of the color filters can have a constant interval on a plane or a horizontal interval of more than 0 µm and less than or equal to 20 µm.

Below, we will look at the reflected light diffraction characteristics of an embodiment using an ellipse shape formed by merging two ellipses of different eccentricities.

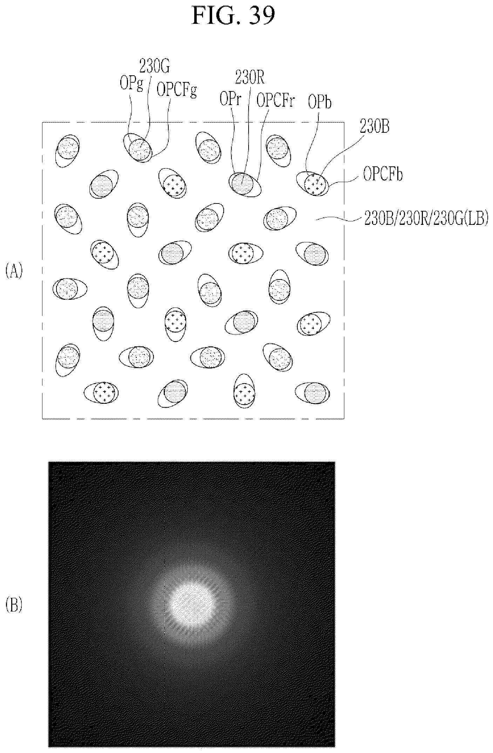

FIG. 39 is a diagram showing a merged elliptical structure and its reflection characteristics according to another embodiment.

(A) of FIG. 39 shows an embodiment in which the openings of each color have the same merged oval shape, but the major axis direction has 4 or more angles.

In (B) of FIG. 39, the diffraction characteristics of the reflected light in (A) of FIG. 39 are shown.

Compared to the comparative example of (A) of FIG. 35, it can be seen that the diffraction characteristic of (B) of FIG. 39 has a blurred reflection diffraction pattern, the ring shape is less clear, and the separated colors are difficult for the user to recognize.

As a result, the example shown in (A) of FIG. 39 can also have improved display quality compared to the comparative example.

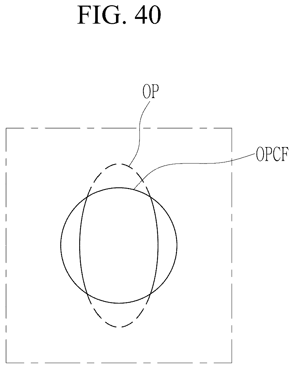

Meanwhile, depending on the embodiment, the second openings OPCFr, OPCFg, OPCFb of the color filters have a circular shape, and the first openings OPr, OPg, OPb of the pixel defining layer 380 have an elliptical shape or a shape similar to an ellipse; this will be briefly discussed with reference to FIG. 40.

FIG. 40 is a plan view of a portion of a display panel according to another embodiment.

In FIG. 40, only the first opening OP of one pixel defining layer 380 and the second opening OPCF of one color filter corresponding thereto are shown.

The second opening OPCF of the color filter has a circular shape, and the first opening OP of the pixel defining layer 380 has an oval shape.

Additionally, the second opening OPCF of the color filter overlaps a portion of the first opening OP of the pixel defining layer 380, and the remaining portion is covered with the light blocking area LB of the color filter.

As a result, the light emitting layer located within the first opening OP of the pixel defining layer 380 may be partially obscured by the light blocking area LB of the color filter.

In FIG. 40, part of the first opening OP of the pixel defining layer 380 is shown as a dotted line to indirectly show that the corresponding part is located below the light blocking area LB of the color filter and is obscured.

Meanwhile, in the embodiment of FIG. 40, due to errors during the actual process, the area covered by the color filter's light blocking area LB in the first opening OP of the pixel defining layer 380 may not be consistent on both the upper and lower sides, and the area on one side may be formed larger.

Additionally, one side of the first opening OP of the pixel defining layer 380 may be located within or in contact with the second opening OPCF of the color filter, and only the other side may be obscured by the light blocking area LB of the color filter.

As in FIG. 40, if a portion of the first opening OP of the pixel defining layer 380 is covered by the shading area of the color filter, the light emitted from the light emitting layer in the first opening OP may not be provided to the front, which may be unfavorable in terms of light efficiency.

However, the size of the first opening OP of the pixel defining layer 380 is related to the lifespan of the light emitting layer located therein, so the size of the first opening OP may not be reduced in order to maintain the lifespan above a certain level.

Depending on the embodiment, the major axis direction of the first opening OP of the pixel defining layer 380 may be arranged in various ways, the angles formed by the major axis may have 4 or more angles, and the angles formed by the major axis may be spaced at an angle of 45 degrees or less.

Depending on the embodiment, ovals with different eccentricities may be formed into a merged shape.

The eccentricities of the two ellipses used for merging may vary, and the size of the merged ellipses may also vary.

Additionally, depending on the embodiment, two ovals with different eccentricities for each color can be merged, and even if they are the same color, two ovals with different eccentricities can be merged to form various ovals.

Meanwhile, the first opening OP of the pixel defining layer 380 and the second opening OPCF of the color filter corresponding thereto may have a horizontal gap of 0 µm or more and 20 µm or less.

The embodiment of FIG. 40 may also be subject to various modifications of Table 2.

The embodiment of FIG. 40 is similar to the embodiment of FIG. 33 described above, and the diffraction patterns generated may be different because the spacing between the two openings is not constant, and as each diffraction pattern is mixed, the overall diffraction pattern is formed to be blurry.

As a result, it is difficult for users to recognize the diffraction pattern, and the degree to which display quality deteriorates is reduced.

Meanwhile, depending on the embodiment, the second opening OPCF of the color filter has a circular shape, and the first opening OP of the pixel defining layer 380 has an elliptical shape, and the two openings are in contact or one opening is located within the other.

In the above, as shown in FIG. 6, the light blocking area LB of the color filter in which at least two or more color filters are overlapped was explained with a focus on an embodiment in which three color filters are overlapped.

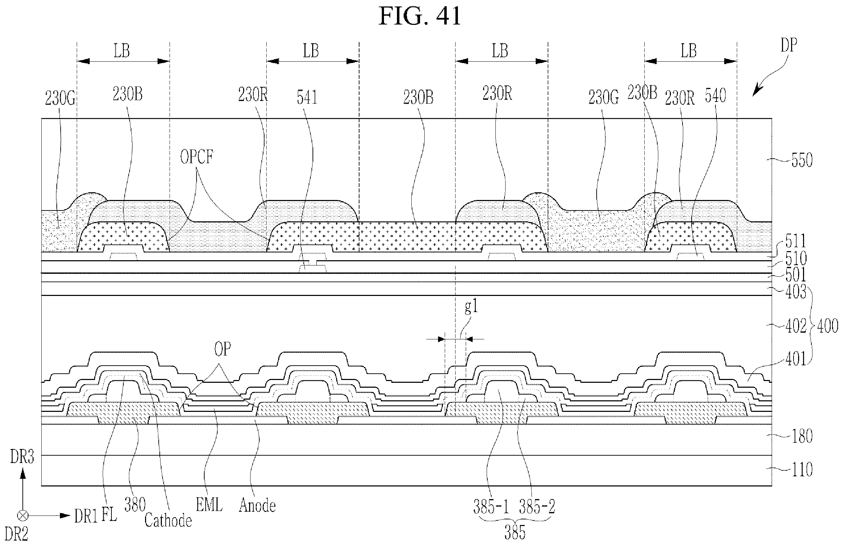

However, depending on the embodiment, the light blocking area LB of the color filter may be formed by overlapping two color filters, which will be discussed in FIG. 41.

FIG. 41 is an enlarged plan view of a partial area of a light emitting display device according to another embodiment.

FIG. 41 is a diagram corresponding to FIG. 6, with only the color filters 230R, 230G, and 230B being different from FIG. 6, so the lower structure of the third sensing insulating layer 511 is the same as that of FIG. 6.

Hereinafter, the upper structure of the third sensing insulating layer 511, which is different from that of FIG. 6 will be explained.

Referring to FIG. 41, a light blocking layer that blocks visible light is not formed, and a blue color filter 230B and a red color filter 230R are sequentially overlapped to block visible light.

The order in which color filters are overlapped may vary depending on the embodiment.

Specifically, the light blocking area LB of the color filter where two color filters are overlapped consists of a blue color filter 230B and a red color filter 230R that are overlapped, and in some areas of the light blocking area LB of the color filter, there is also a part where a green color filter 230G is overlapped.

However, the green color filter 230G is not formed throughout the light blocking area LB of the color filter, so unlike the embodiment of FIG. 6, this is an embodiment in which only two color filters form the blocking area of the color filter.

The light blocking area LB of the color filter, where two color filters are overlapped, is located only in the area overlapping the pixel defining layer 380 on the plane, and one side of the light blocking area LB of the color filter is arranged inward from one side corresponding to the pixel defining layer 380.

Only one color filter can be located in the area excluding the light blocking area LB of the color filter, and light of the color of the color filter is transmitted to form the light transmitting area of the color filter or the second opening OPCF of the color filter.

The area of the second opening OPCF is larger than that of the first opening OP of the pixel defining layer 380, and the first opening OP of the pixel defining layer 380 on the plane can be located within the second opening OPCF of the color filter.

In addition to the pixel defining layer 380, the light blocking area LB of the color filter overlaps the spacer 385 and the plurality of sensing electrodes 540 and 541 on a plane.

Specifically, the light blocking area LB of the color filter is disposed inward at a certain distance g1 from the corresponding side of the pixel defining layer 380 of the spacer 385, and the spacer 385 blocks the light of the color filter.

Additionally, the plurality of sensing electrodes 540 and 541 are covered on a plane with the light blocking area LB of the color filter.

As a result, when viewed from the front of the display panel DP, the spacer 385 and the plurality of sensing electrodes 540 and 541 may not be visible because they are obscured by the light blocking area LB of the color filter.

Depending on the embodiment, the color filters 230R, 230G, and 230B may be replaced with a color conversion layer or may further include a color conversion layer.

The color conversion layer may include quantum dots.

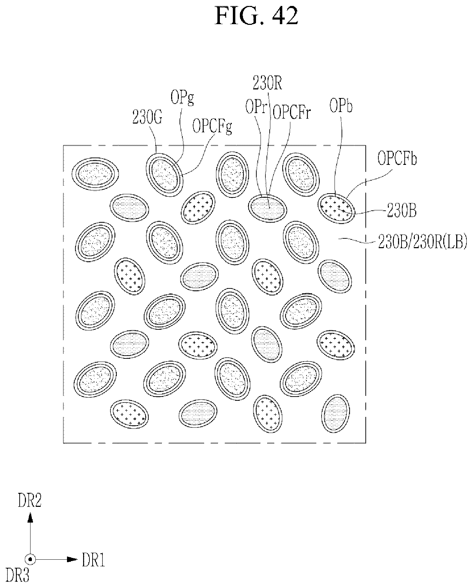

An embodiment having a cross-sectional structure as shown in FIG. 41 may have a planar structure as shown in FIG. 42.

FIG. 42 is a plan view of a portion of a display panel according to another embodiment.

FIG. 42 is a plan view corresponding to FIG. 7. Unlike the embodiment of FIG. 7, the boundary of the green color filter 230G is further shown outside the green second opening OPCFg among the second openings of the color filter, thereby creating a green color filter, to clearly show that the green color filter 230G has an island-shaped structure, and that the boundary of the green color filter 230G partially overlaps the light blocking area LB of the color filter.

Here, separate boundaries between the red color filter 230R and the blue color filter 230B are not shown, which means that the red color filter 230R and the blue color filter 230B are formed continuously at the border of the second opening of each color filter and the light shading area of the color filter.

Although not shown in FIG. 42, boundaries of color filters of different colors may be positioned around the second opening of the color filter so that only one color filter is positioned in the second opening of the color filter.

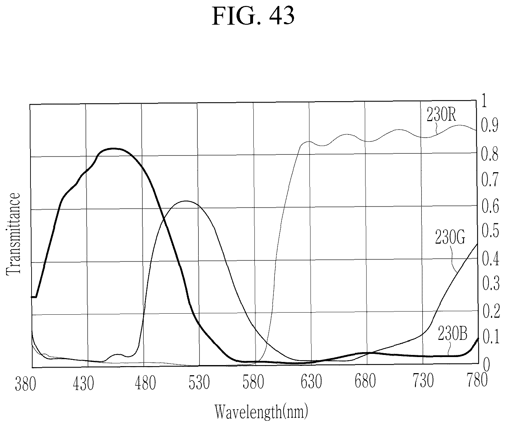

Below, an examination of FIG. 43 will show whether two color filters can be overlapped to replace the role of a light blocking layer.

FIG. 43 is a graph showing the transmittance according to the wavelength of the color filter.

FIG. 43 is a graph of the transmittance for the wavelengths of each color filter 230R, 230G, and 230B, so light in higher wavelengths is transmitted.

Referring to FIG. 43, each color filter 230R, 230G, 230B has a transmittance of less than 10% for parts other than the wavelength band that is transmitted through it, and when three or two color filters overlap, it can be confirmed that there is almost no transmitted wavelength band.

Therefore, the role of a light blocking layer can be replaced by overlapping at least two color filters, and the light blocking layer can be replaced by overlapping three color filters as shown in FIG. 6 or by overlapping two color filters as shown in FIG. 41.

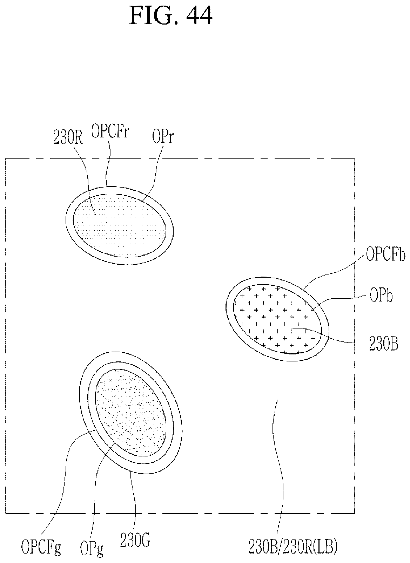

Hereinafter, a modified embodiment of FIG. 42 will be explained through FIG. 44.

FIG. 44 is a plan view of a portion of a display panel according to another embodiment.

FIG. 44 shows an example in which one unit pixel includes one red-, one green-, and one blue-light emitting area.

Specifically, the pixel defining layer 380 includes one each of the red first opening OPr, the green first opening OPg, and the blue first opening OPb, and the red second opening OPCFr, the green second opening OPCFg, and the blue second opening OPCFb of the color filter are included in each unit pixel.

In FIG. 44, the boundary of the green color filter 230G is further shown on the outside of the green second opening OPCFg, which has an island-like structure, and it can be confirmed that the boundary of the green color filter 230G partially overlaps the shading area of the color filter.

This embodiment of FIG. 44 is different from the embodiment of FIG. 42 in which a unit pixel includes four light emitting areas.

For reference, in the embodiment of FIG. 42, a unit pixel is shown including two green-light emitting areas, one blue-light emitting area, and one red-light emitting area.

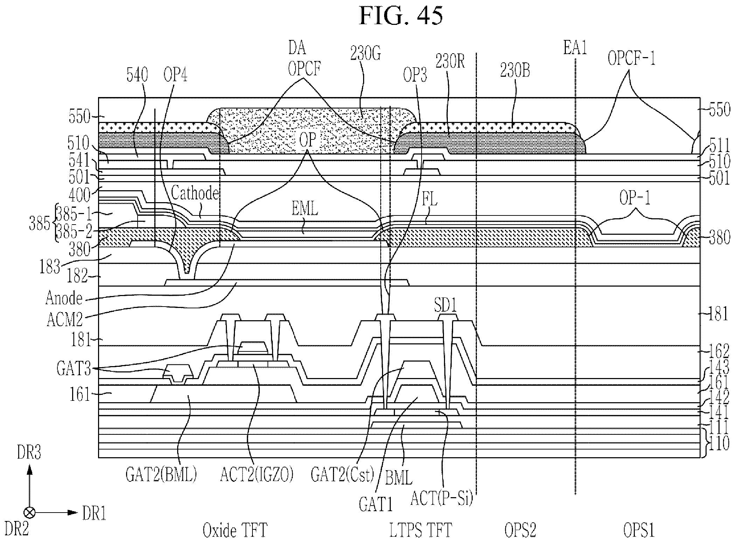

Hereinafter, with reference to FIG. 45, a more detailed cross-sectional view of an embodiment is shown in which the color filters 230R, 230G, and 230B are formed by overlapping and does not include a light blocking layer.

FIG. 45 shows an embodiment in which a light blocking area LB of the color filter is formed by overlapping the blue color filter 230B and the red color filter 230R.

FIG. 45 is a cross-sectional view of a light emitting display device according to another embodiment.

In FIG. 45, in addition to the stacked structure of the display area DA, the stacked structure of the first component area EA1 is shown.

A light emitting display device can be largely divided into a lower panel layer and an upper panel layer. The lower panel layer is where the light emitting diodes and pixel circuitry that make up the pixel are located, and may even include an encapsulation layer 400 that covers it.

Here, the pixel circuit portion includes the second organic layer 182 and the third organic layer 183, and refers to the lower part thereof, the light emitting diode is the upper part of the third organic layer 183, and is located on the bottom of the encapsulation layer 400.

The structure located on top of the encapsulation layer 400 may correspond to the upper panel layer.

Referring to FIG. 45, a metal layer BML is located on the substrate 110.

The substrate 110 may include a material that has rigid properties and does not bend, such as glass, or may include a flexible material that can bend, such as plastic or polyimide.

In the case of a flexible substrate, as shown in FIG. 45, it may have a double-layer structure of polyimide and a barrier layer formed of an inorganic insulating material thereon.

The metal layer BML may be formed in a position that overlaps the channel of the driving transistor T1 in a plane among the subsequent first semiconductor layers, and is also called a lower blocking layer.

The metal layer BML may include a metal or metal alloy such as copper (Cu), molybdenum (Mo), aluminum (Al), or titanium (Ti).

A buffer layer 111 covers the substrate 110 and the metal layer BML.

The buffer layer 111 serves to block the penetration of impure elements into the first semiconductor layer ACT (P-Si) and is an inorganic insulating material containing silicon oxide (SiOx), silicon nitride (SiNx), silicon oxynitride (SiONx), etc.

A first semiconductor layer ACT(P-Si) formed of a silicon semiconductor (e.g., polycrystalline semiconductor (P-Si)) is located on the buffer layer 111.

The first semiconductor layer ACT(P-Si) includes a channel of a polycrystalline transistor (LTPS) TFT including the driving transistor T1, and a first region and a second region located on both sides thereof.

Here, the polycrystalline transistor LTPS TFT may include a driving transistor T1 as well as various switching transistors or compensation transistors.

Additionally, the first semiconductor layer ACT(P-Si) has regions on both sides of the channel that have conductive layer characteristics through plasma treatment or doping, and can serve as the first and second electrodes of the transistor.

A first gate insulating layer 141 may be positioned on the first semiconductor layer ACT(P-Si).

The first gate insulating layer 141 may be an inorganic insulating layer containing silicon oxide (SiOx), silicon nitride (SiNx), or silicon oxynitride (SiONx).

A first gate conductive layer including the gate electrode GAT1 of a polycrystalline transistor LTPS TFT may be positioned on the first gate insulating layer 141.

The first gate conductive layer may be formed with a first scan line or an emission control line in addition to the gate electrode of the polycrystalline transistor LTPS TFT.

The first gate conductive layer may include a metal or metal alloy such as copper (Cu), molybdenum (Mo), aluminum (Al), or titanium (Ti), and may be composed of a single layer or multiple layers.

After forming the first gate conductive layer, a plasma treatment or doping process may be performed to make the exposed area of the first semiconductor layer conductive.

That is, the first semiconductor layer ACT(P-Si) masked by the first gate conductive layer is not doped, and the portion of the first semiconductor layer ACT(P-Si) not covered by the first gate conductive layer can have the same characteristics as the conductive layer.

A second gate insulating layer 142 may be positioned on the first gate conductive layer and the first gate insulating layer 141.

The second gate insulating layer 142 may be an inorganic insulating layer containing silicon oxide (SiOx), silicon nitride (SiNx), or silicon oxynitride (SiONx).

A second gate conductive layer including one electrode GAT2(Cst) of the storage capacitor Cst and the lower blocking layer GAT2(BML) of the oxide transistor Oxide TFT may be located on the second gate insulating layer 142.

The lower blocking layer GAT2(BML) of the oxide transistor Oxide TFT is located at the bottom of the channel of each oxide transistor Oxide TFT, and serves to block light or electromagnetic interference provided to the channel from the bottom.

Meanwhile, one electrode GAT2(Cst) of the storage capacitor Cst overlaps the gate electrode GAT1 of the driving transistor T1 to form the storage capacitor Cst.

Depending on the embodiment, the second gate conductive layer may further include a scan line, a control line, or a voltage line.

The second gate conductive layer may include a metal or metal alloy such as copper (Cu), molybdenum (Mo), aluminum (Al), or titanium (Ti), and may be composed of a single layer or multiple layers.

A first interlayer-insulating layer 161 may be positioned on the second gate conductive layer.

The first interlayer-insulating layer 161 may include an inorganic insulating layer containing silicon oxide (SiOx), silicon nitride (SiNx), or silicon oxynitride (SiONx). Depending on the embodiment, the inorganic insulating material may be formed thickly.

An oxide semiconductor layer ACT2(IGZO) including a channel, a first region, and a second region of an oxide transistor Oxide TFT may be positioned on the first interlayer-insulating layer 161.

A third gate insulating layer 143 may be located on the oxide semiconductor layer ACT2(IGZO).

The third gate insulating layer 143 may be located on the entire surface of the oxide semiconductor layer ACT2(IGZO) and the first interlayer-insulating layer 161.

The third gate insulating layer 143 may include an inorganic insulating layer containing silicon oxide (SiOx), silicon nitride (SiNx), or silicon oxynitride (SiONx).

A third gate conductive layer GAT3 including the gate electrode of an oxide transistor Oxide TFT may be positioned on the third gate insulating layer 143.

The gate electrode of an oxide transistor Oxide TFT may overlap the channel.

The third gate conductive layer GAT3 may further include a scan line or a control line, and may additionally include a connection electrode connected to the lower blocking layer GAT2(BML) of the oxide transistor Oxide TFT.

The third gate conductive layer GAT3 may contain a metal or metal alloy such as copper (Cu), molybdenum (Mo), aluminum (Al), or titanium (Ti), and may be composed of a single layer or multiple layers.

A second interlayer-insulating layer 162 may be positioned on the third gate conductive layer GAT3.

The second interlayer-insulating layer 162 may have a single layer or multiple layers.

The second interlayer-insulating layer 162 may include an inorganic insulating material such as silicon nitride (SiNx), silicon oxide (SiOx), or silicon nitride (SiOxNy), and may include an organic material depending on the embodiment.

A first data conductive layer SD1 is positioned on the second interlayer-insulating layer 162 and includes a connection electrode that can be connected to the first and second regions of each of the polycrystalline transistor LTPS TFT and the oxide transistor Oxide TFT.

The first data conductive layer SD1 may include a metal or metal alloy such as aluminum (Al), copper (Cu), molybdenum (Mo), or titanium (Ti), and may be composed of a single layer or multiple layers.

The first organic layer 181 may be positioned on the first data conductive layer SD1.

The first organic layer 181 may be an organic insulating layer containing an organic material, and the organic material includes one or more materials selected from the group consisting of polyimide, polyamide, acrylic resin, benzocyclobutene, and phenol resin.

A second data conductive layer including an anode connection electrode ACM2 may be positioned on the first organic layer 181.

The second data conductive layer may include a data line or a driving voltage line.

The second data conductive layer SD2 may include a metal or metal alloy such as aluminum (Al), copper (Cu), molybdenum (Mo), or titanium (Ti), and may be composed of a single layer or multiple layers.

Above the second data conductive layer, the second organic layer 182 and the third organic layer 183 are located, and an anode connection opening OP4 is defined in the second organic layer 182 and the third organic layer 183.

The anode connection electrode ACM2 is electrically connected to the anode through the anode connection opening OP4.

The second organic layer 182 and the third organic layer 183 may be organic insulating layers, and may include one or more materials selected from the group consisting of polyimide, polyamide, acrylic resin, benzocyclobutene, and phenol resin.

Depending on the embodiment, the third organic layer 183 may be omitted.

A pixel defining layer 380 may be positioned on the anode and has a first opening OP exposing the anode and covers at least a portion of the anode.

The pixel defining layer 380 may be a black pixel defining layer formed of a black organic material to prevent light applied from the outside from being reflected back to the outside. Depending on the embodiment, the pixel defining layer 380 may be formed of a transparent organic material.

Therefore, depending on the embodiment, the pixel defining layer 380 may include a negative-type black organic material and a black pigment.

A spacer 385 is located on the pixel defining layer 380.

The spacer 385 may include a first part 385-1 that is tall and narrow, and a second part 385-2 that is low and wide.

Unlike the pixel defining layer 380, the spacer 385 may be formed of a transparent organic insulating material.

Depending on the embodiment, the spacer 385 may be formed of a positive-type transparent organic material.

A functional layer FL and a cathode are sequentially formed on the anode, the spacer 385, and the pixel defining layer 380, and in the display area DA and the first component area EA1, the functional layer FL and cathode can be located in all areas.

The light emitting layer EML is located between the functional layers FL, and the light emitting layer EML may be located only within the first opening OP of the pixel defining layer 380.

Hereinafter, the functional layer FL and the light emitting layer EML can be merged to refer to the intermediate layer.

The functional layer FL can include at least one auxiliary layer such as an electron injection layer, an electron transport layer, a hole transport layer, and a hole injection layer, the hole injection layer and the hole transport layer may be located under the light emitting layer EML, and the electron transport layer and the electron injection layer may be located on top of the light emitting layer EML.

An encapsulation layer 400 is located on the cathode.

The encapsulation layer 400 includes at least one inorganic layer and at least one organic layer, and depending on the embodiment, may have a triple-layer structure including a first inorganic encapsulation layer, an organic encapsulation layer, and a second inorganic encapsulation layer.

The encapsulation layer 400 may be used to protect the light emitting layer EML from moisture or oxygen that may enter from the outside.

Depending on the embodiment, the encapsulation layer 400 may include a structure in which an inorganic layer and an organic layer are further sequentially stacked.

Sensing insulating layers 501, 510, 511 and a plurality of sensing electrodes 540, 541 are positioned on the encapsulation layer 400 for touch detection.

In the embodiment of FIG. 45, touch can be detected in a capacitive manner using two sensing electrodes 540 and 541.

Specifically, a first sensing insulating layer 501 is formed on the encapsulation layer 400, and a plurality of sensing electrodes 540 and 541 are formed thereon.

The plurality of sensing electrodes 540 and 541 may be insulated with the second sensing insulating layer 510 interposed therebetween, and some of them may be electrically connected through an opening located in the second sensing insulating layer 510.

Here, the sensing electrodes 540 and 541 are made of metal or metal alloy such as aluminum (Al), copper (Cu), silver (Ag), gold (Au), molybdenum (Mo), titanium (Ti), and tantalum TA, and they may include a single layer or multiple layers.

A third sensing insulating layer 511 is formed on the sensing electrode 540.

The color filters 230R, 230G, and 230B are located on the third sensing insulating layer 511.

In the embodiment of FIG. 45, a light blocking layer is not included, and the role of the light blocking layer is performed by the overlapped color filters 230R, 230B, and the overlapped color filters 230R, 230B can be positioned to overlap the detection electrodes 540, 541 on a plane.

The overlapped color filters 230R and 230B have a second opening OPCF, and the second opening OPCF of the overlapped color filters 230R and 230B overlaps the first opening OP of the pixel defining layer 380 on a plane.

Additionally, the second opening OPCF of the overlapped color filters 230R and 230B may be wider than the first opening OP of the pixel defining layer 380.

As a result, the anode that overlaps the first opening OP of the pixel defining layer 380 (i.e., exposed by the first opening OP of the pixel defining layer 380) also overlaps the color filters 230R and 230B, so it is possible to have a structure that is not obscured in plan view.

This is to ensure that the anode and the light emitting layer EML capable of displaying an image are not obscured by the overlapped color filters 230R and 230B and the sensing electrodes 540 and 541.

Additionally, the overlapped color filters 230R and 230B have a structure that overlaps the anode connection opening OP4 on a plane.

One color filter may be located within the second opening OPCF of the overlapped color filters 230R and 230B, and in FIG. 45, a green color filter 230G is located.

Depending on the embodiment, the color filters 230R, 230G, and 230B may be replaced with a color conversion layer or may further include a color conversion layer.

The color conversion layer may include quantum dots.

A planarization layer 550 covering the color filters 230R, 230G, and 230B is positioned on the color filters 230R, 230G, and 230B.

The planarization layer 550 is used to planarize the upper surface of the light emitting display device, and may be a transparent organic insulating layer containing one or more materials selected from the group consisting of polyimide, polyamide, acrylic resin, benzocyclobutene, and phenol resin.

Depending on the embodiment, a low refractive layer and an additional planarization layer may be further positioned on the planarization layer 550 to improve frontal visibility and light output efficiency of the display device.

Light can be refracted and emitted toward the front by the low refractive layer and the additional flattening layer with high refractive characteristics.

In this case, depending on the embodiment, the planarization layer 550 may be omitted and a low refractive layer and an additional planarization layer may be located directly on the color filter.

In this embodiment, a polarizer is not included on top of the planarization layer 550.

In other words, the polarizer can play a role in preventing display quality from deteriorating when external light is incident and reflected by an anode, etc., and is visible to the user.

However, in this embodiment, the side of the anode is covered with the pixel defining layer 380 to reduce the degree of reflection from the anode, and overlapped color filters 230R and 230B are also formed to reduce the degree of incident light; in short, it already includes a structure that prevents deterioration of display quality due to reflection.

Therefore, there is no need to separately form the polarizer on the front of the display panel DP.

Meanwhile, in FIG. 45, in addition to the stacked structure of the display area DA, the cross-sectional structure of the first component area EA1, which is formed to allow light to transmit through a portion of the display area DA, is also shown.

In FIG. 45, the first component area EA1 is divided into a first optical sensor area (OPS1; also referred to as a transmissive optical sensor area) and a second optical sensor area (OPS2; also referred to as a non-transmissive optical sensor area).

Here, the first optical sensor area OPS1 is a region formed to allow light to pass through by having additional openings OP-1, OPCF-1 located so as not to overlap in plane the black pixel defining layer 380 and the light blocking area LB of the color filter formed by overlapping at least two color filters.

In contrast, the second optical sensor area OPS2 is an area formed to overlap on a plane the black pixel defining layer 380 and the light blocking area LB of the color filter formed by overlapping at least two color filters so that light does not pass through.

Both the first optical sensor area OPS1 and the second optical sensor area OPS2 of the first component area EA1 may not include a layer that blocks light, such as a metal layer or a semiconductor layer.

For reference, the first optical element (ES1; refer to FIG. 2) is located on the back side of the first component area EA1, and the front side of the light emitting display device can be detected through the first optical sensor area OPS1 located in the first component area EA1.

Specifically, the layered structure of the first component area EA1 is as follows.

The buffer layer 111, which is an inorganic insulating layer, is positioned on the substrate 110, and the first gate insulating layer 141 and the second gate insulating layer 142, which are inorganic insulating layers, are sequentially positioned thereon.

Additionally, a first interlayer-insulating layer 161, a third gate insulating layer 143, and a second interlayer-insulating layer 162, which are inorganic insulating layers, are sequentially stacked on the second gate insulating layer 142.

On the second interlayer-insulating layer 162, a first organic layer 181, a second organic layer 182, and a third organic layer 183, which are organic insulating layers, are sequentially stacked.

A functional layer FL may be located on the third organic layer 183, above which may be a cathode.

The encapsulation layer 400 is positioned on the cathode, and the sensing insulating layers 501, 510, and 511 are sequentially positioned on top of the cathode.

The encapsulation layer 400 may have a triple-layer structure sequentially including an inorganic encapsulation layer, an organic encapsulation layer, and an inorganic encapsulation layer.

Additionally, the sensing insulating layers 501, 510, and 511 may all be inorganic insulating layers.

A planarization layer 550 may be positioned on the sensing insulating layers 501, 510, and 511.

The first component area EA1 as described above, the metal layer, the first semiconductor layer, the first gate conductive layer, the second gate conductive layer, the oxide semiconductor layer, the third gate conductive layer, the first data conductive layer, the second data conductive layer, and the anode are not located.

Additionally, the light emitting layer EML and the sensing electrodes 540 and 541 are not formed.

Additionally, in the first optical sensor area OPS1 of the first component area EA1, additional openings OP-1, OPCF-1 are formed in the pixel defining layer 380 and the light blocking area LB of the color filter, respectively, so that the pixel defining layer 380 and a color filter may not be formed.

As a result, light may pass through the first optical sensor area OPS1.

On the other hand, the second optical sensor area OPS2 of the first component area EA1 may have a structure in which the additional openings OP-1, OPCF-1 are not located, so that light is not transmitted by overlapping the pixel defining layer 380 and the light blocking area LB of the color filter.

In the above, an embodiment in which a total of three organic layers are formed, and an anode connection opening is defined in the second organic layer and the third organic layer has been explained.

However, at least two organic layers may be formed, and in this case, the anode connection opening may be located in the upper organic layer located away from the substrate, and the lower organic layer opening may be located in the lower organic layer.

Although the embodiments have been described in detail above, the scope of the present invention is not limited thereto, and various modifications and improvements can be made by those skilled in the art using the basic concepts of the present invention defined in the following claims.

## Claims

1. A light emitting display device (1000), comprising:
a substrate (110);
a plurality of anodes located on the substrate (110);
a pixel defining layer (380) defining a plurality of first openings (OP) overlapping the plurality of anodes, respectively;
a plurality of light emitting layers (EML) located within the plurality of first openings (OP) of the pixel defining layer (380), respectively;
a cathode disposed on the plurality of light emitting layers (EML) and the pixel defining layer (380);
an encapsulation layer (400) located on the cathode; and
a plurality of color filters (230) corresponding to different colors and located on the encapsulation layer (400),
wherein the plurality of color filters (230) define a plurality of second openings (OPCF) in each of which only one color filter (230) of the plurality of color filters (230) is located, and include a light blocking area (LB) in which at least two color filters (230) of the plurality of color filters (230) are overlapped in a plan view, and
at least one first opening (OP) among the plurality of first openings (OP) of the pixel defining layer (380) and at least one second opening (OPCF) among the plurality of second openings (OPCF) of the color filter (230) each has an oval shape in the plan view.

2. The light emitting display device (1000) of claim 1, wherein:
a first opening (OP) among the plurality of first openings (OP) and a second opening (OPCF), which overlaps the first opening (OP) in the plan view, among the plurality of second openings (OPCF) have a same major axis direction or an angle of 20 degrees or less between major axis directions thereof.

3. A light emitting display device (1000), comprising:
a substrate (110);
a plurality of anodes located on the substrate (110);
a pixel defining layer (380) defining a plurality of first openings (OP) overlapping the plurality of anodes, respectively;
a plurality of light emitting layers (EML) located within the plurality of first openings (OP) of the pixel defining layer (380), respectively;
a cathode disposed on the plurality of light emitting layers (EML) and the pixel defining layer (380);
an encapsulation layer (400) located on the cathode; and
a plurality of color filters (230) corresponding to different colors and located on the encapsulation layer (400),
wherein the plurality of color filters (230) define a plurality of second openings (OPCF) in each of which only one color filter (230) of the plurality of color filters (230) is located, and include a light blocking area (LB) in which at least two color filters (230) of the plurality of color filters (230) are overlapped in a plan view, and
one of a first opening (OP) of the pixel defining layer (380) among the plurality of first openings (OP) and a second opening (OPCF) of the color filter (230) overlapping the first opening (OP), among the second openings (OPCF), has a circular shape, and the other of the first opening (OP) and the second opening (OPCF) has an oval shape in the plan view.

4. The light emitting display device (1000) of claim 3, wherein:
the first opening (OP) has the circular shape, and the second opening (OPCF) has the oval shape, and
borders of the first opening (OP) and the second opening (OPCF) are in contact with each other in the plan view.

5. The light emitting display device (1000) of claim 3, wherein:
the first opening (OP) has the circular shape, and the second opening (OPCF) has the oval shape, and
the first opening (OP) is located within the second opening (OPCF) in the plan view.

6. The light emitting display device (1000) of claim 3, wherein:
the first opening (OP) has the circular shape, and the second opening (OPCF) has the oval shape, and
a portion of the first opening (OP) overlaps the second opening (OPCF), and a remaining portion of the first opening (OP) overlaps the light blocking area (LB) of the color filter (230) in the plan view.

7. The light emitting display device (1000) of claim 3, wherein:
the first opening (OP) has the oval shape, and the second opening (OPCF) has the circular shape.

8. The light emitting display device (1000) of at least one of claims 1 to 7, wherein:
the openings having the oval shape are disposed with their major axes in four or more different angles with respect to a basis direction,
an angle formed by major axes of two first openings (OP) and/or an angle formed by major axes of two second openings (OPCF) is 45 degrees or less, especially wherein the major axes angles of the first openings (OP) and/or the major axis angles of the second openings (OPCF) are arranged at intervals of 45 degrees or less.

9. The light emitting display device (1000) of at least one of claims 1 to 8, wherein:
the oval shape has an eccentricity of 0.2 to 0.85.

10. The light emitting display device (1000) of at least one of claims 1 to 9, wherein:
the plurality of first openings (OP) and the plurality of second openings (OPCF) overlapping the first openings (OP) in the plan view are formed at regular intervals in the plan view.

11. The light emitting display device (1000) of at least one of claims 1 to 10, wherein:
a first opening (OP) among the plurality of first openings (OP) and a second opening (OPCF), which overlaps the first opening (OP) in the plan view, among the plurality of second openings (OPCF) have a horizontal gap of more than 0 µm and less than or equal to 20 µm.

12. The light emitting display device (1000) of at least one of claims 1 to 11, wherein:
the oval shape is a shape that merges portions of at least two elliptical shapes with different eccentricities in the plan view.

13. The light emitting display device (1000) of claim 12, wherein:
the oval shape is a planar shape formed by cutting a first ellipse with a first eccentricity and a second ellipse with a second eccentricity in a first direction and then merging a cut portion of the first ellipse and a cut portion of the second ellipse.

14. The light emitting display device (1000) of at least one of claims 1 to 13, wherein:
in the light blocking area (LB) of the color filter (230), a blue color filter (230B) and a red color filter (230R) overlap each other,
each of the plurality of second openings (OPCF) overlaps one of the blue color filter (230B), the red color filter (230R), and a green color filter (230G).

15. The light emitting display device (1000) of at least one of claims 1 to 14, wherein:
the openings having the oval shape are disposed with their major axes in four or more different angles with respect to a basis direction, and
the major axes angles of the first openings (OP) and/or the major axis angles of the second openings (OPCF) are arranged at irregular intervals.
